(19) Europäisches Patentamt
European Patent Office
Office européen des brevets

(11) **EP 3 776 612 B1**

(12) **EUROPÄISCHE PATENTSCHRIFT**

(45) Veröffentlichungstag und Bekanntmachung des Hinweises auf die Patenterteilung:
**30.03.2022 Patentblatt 2022/13**

(21) Anmeldenummer: **18727209.1**

(22) Anmeldetag: **17.05.2018**

(51) Internationale Patentklassifikation (IPC):
*H01G 9/26* <sup>(2006.01)</sup>      *G01R 31/36* <sup>(2020.01)</sup>
*H01G 9/28* <sup>(2006.01)</sup>      *H02H 7/16* <sup>(2006.01)</sup>
*H01G 4/40* <sup>(2006.01)</sup>      *H01G 4/38* <sup>(2006.01)</sup>
*H01G 2/16* <sup>(2006.01)</sup>      *H01G 9/00* <sup>(2006.01)</sup>
*H01G 11/10* <sup>(2013.01)</sup>     *H01G 11/16* <sup>(2013.01)</sup>
*G01R 31/64* <sup>(2020.01)</sup>

(52) Gemeinsame Patentklassifikation (CPC):
**H01G 9/26; G01R 31/64; H01G 2/16; H01G 4/38; H01G 4/40; H01G 9/0003; H01G 9/28; H01G 11/10; H01G 11/16**

(86) Internationale Anmeldenummer:
**PCT/EP2018/062917**

(87) Internationale Veröffentlichungsnummer:
**WO 2019/219197 (21.11.2019 Gazette 2019/47)**

(54) **KONDENSATORBANK**

CAPACITOR BANK

BATTERIE DE CONDENSATEURS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**17.02.2021 Patentblatt 2021/07**

(73) Patentinhaber: **Siemens Energy Global GmbH & Co. KG**
**81739 München (DE)**

(72) Erfinder:
• **ARMSCHAT, Christoph**
**91058 Erlangen (DE)**
• **YAMAZAKI, Sergio**
**07024-010 Guarulhos (BR)**

(56) Entgegenhaltungen:
DE-A1-102012 204 958      US-A- 3 755 711
US-A- 4 219 856            US-A1- 2002 089 802
US-A1- 2009 231 764        US-A1- 2017 059 639

**Beschreibung**

Die Erfindung betrifft eine Kondensatorbank, die eine Mehrzahl von Kondensatoreinheiten aufweist, sowie ein Verfahren zum Überwachen einer derartigen Kondensatorbank.

US 2017/059639 A1 offenbart ein Verfahren zum Überwachen einer Kondensatorbank.

Eine Kondensatorbank, insbesondere eine Hochspannungs-Kondensatorbank, weist in der Regel eine Mehrzahl von Kondensatoreinheiten auf. Dabei weisen die Kondensatoreinheiten jeweils eine Mehrzahl von elektrischen Kondensatorelementen auf, welche beispielsweise als sogenannte Kondensatorwickel ausgestaltet sind. Beispielsweise kann eine Kondensatorbank 300 Kondensatoreinheiten aufweisen, wobei jede Kondensatoreinheit beispielsweise 70 Kondensatorelemente aufweist.

Wenn ein einzelnes Kondensatorelement ausfällt (beispielsweise aufgrund eines Durchschlags des Kondensatorelements oder eines Kurzschlusses im Kondensatorelement), dann ändert sich durch diesen Ausfall eines einzelnen Kondensatorelements die Kapazität der Kondensatoreinheit nur geringfügig. Die sich aufgrund des Ausfalls des Kondensatorelements ergebende Änderung bei dem durch die Kondensatoreinheit fließenden Strom und/oder bei der über der Kondensatoreinheit auftretenden Spannung (Kondensatoreinheiten-Spannung) ist ebenfalls sehr gering.

Solche Ausfälle von einzelnen Kondensatorelementen können insbesondere dann auftreten, wenn den Kondensatorelementen jeweils eine eigene Sicherung zugeordnet ist. Bei Ausfall eines solchen Kondensatorelements und dem Durchbrennen der zugehörigen Sicherung tritt nur eine sehr geringe Änderung der Kapazität der Kondensatoreinheit und folglich nur eine sehr geringe Änderung des Stroms oder der Spannung der betroffenen Kondensatoreinheit auf.

Um diese geringe Änderung direkt zu messen, müsste man sehr genaue und damit teure Messgeräte einsetzen. Insbesondere in Industrieumgebungen würden dennoch Probleme auftreten, um diese geringen Spannungs- oder Stromstärkeänderungen von Störungen und elektrischem Rauschen zu unterscheiden. Ein Erkennen von ausfallenden Kondensatorelementen ist dennoch wichtig: Da in den Kondensatoreinheiten oftmals parallel geschaltete Kondensatorelemente angeordnet sind, kann nämlich ein Ausfall von einem (oder mehreren) der parallel geschalteten Kondensatorelemente beispielsweise zu einer gefährlichen Überladung der anderen Kondensatorelemente der Parallelschaltung führen.

Der Erfindung liegt die Aufgabe zugrunde, ein Verfahren und eine Anordnung anzugeben, mit denen sicher und zuverlässig bereits der Ausfall eines einzigen Kondensatorelements erkannt werden kann.

Diese Aufgabe wird erfindungsgemäß gelöst durch ein Verfahren und durch eine Anordnung gemäß den unabhängigen Patentansprüchen. Vorteilhafte Ausführungsformen des Verfahrens und der Anordnung sind in den abhängigen Patentansprüchen angegeben.

Offenbart wird ein Verfahren zum Überwachen einer Kondensatorbank (insbesondere einer Hochspannungs-Kondensatorbank), die eine Mehrzahl von Kondensatoreinheiten aufweist, wobei jede Kondensatoreinheit eine Mehrzahl von elektrischen Kondensatorelementen aufweist, und wobei die Kondensatoreinheiten in mehrere Gruppen von Kondensatoreinheiten aufgeteilt sind und jeder Gruppe von Kondensatoreinheiten eine (eigene) Gruppen-Überwachungseinheit zugeordnet ist,

wobei bei dem Verfahren

- jede Gruppe von Kondensatoreinheiten mittels der zugeordneten Gruppen-Überwachungseinheit auf einen Ausfall eines Kondensatorelements in einer der Kondensatoreinheiten der Gruppe hin überwacht wird, und
- bei einem Erkennen eines solchen Ausfalls eines Kondensatorelements Daten, die diesen Ausfall des Kondensatorelements beschreiben, von der Gruppen-Überwachungseinheit zu einem (zentralen) Überwachungsempfänger übermittelt werden.

Dabei ist der Überwachungsempfänger mehreren Gruppen von Kondensatoreinheiten zugeordnet. Beispielsweise leitet der Überwachungsempfänger die Daten an eine Überwachungszentrale für die Kondensatorbank weiter.

Hierbei ist vorteilhaft, dass jeder Gruppe von Kondensatoreinheiten eine eigene Gruppen-Überwachungseinheit zugeordnet ist, die ausschließlich diese Gruppe von Kondensatoreinheiten auf einen Ausfall eines Kondensatorelements hin überwacht. Dadurch wird die Überwachung der Kondensatorbank auf die Gruppen-Überwachungseinheiten der einzelnen Gruppen verteilt, so dass jede Gruppe von Kondensatoreinheiten unabhängig von den anderen Gruppen überwacht wird. Dadurch ergibt sich zum einen eine zuverlässige Überwachung der einzelnen Gruppen. Zum anderen ist jede Gruppen-Überwachungseinheit für die Überwachung einer geringeren Anzahl von Kondensatoreinheiten zuständig (verglichen mit der Gesamtanzahl der Kondensatoreinheiten der Kondensatorbank), so dass diese Gruppen-Überwachungseinheit den Ausfall eines einzigen Kondensatorelements zuverlässiger erkennen kann. Vorzugsweise weist jede Gruppe zwischen 2 und 8 Kondensatoreinheiten auf.

Das Verfahren kann so ausgestaltet sein, dass Daten über die Kondensatoreinheit mit dem ausgefallenen Kondensatorelement von der Gruppen-Überwachungseinheit zu dem Überwachungsempfänger übermittelt werden. Aufgrund dieser Daten kann vorteilhafterweise genau die Kondensatoreinheit mit dem ausgefallenen Kondensatorelememt identifiziert werden. Diese Kondensatoreinheit kann dann zum Beispiel zielgerichtet ausgetauscht werden, eine zeitraubende Suche nach der betroffen Kondensatoreinheit (zum Beispiel mittels einer Kapazitätsmessbrücke) wird vermieden.

Das Verfahren kann so ausgestaltet sein, dass die in den Kondensatoreinheiten angeordneten Kondensatorelemente elektrisch parallel und/oder in Reihe geschaltet sind. Durch die Anordnung der Kondensatorelemente in elektrischen Reihenschaltungen und/oder Parallelschaltungen können für die Kondensatoreinheiten die Kondensatoreinheiten-Spannungen und Kondensatoreinheiten-Ströme in weiten Grenzen an die Bedürfnisse angepasst werden. Dies ist insbesondere für Hochspannungs-Kondensatorbänke von Vorteil, bei denen von jeder einzelnen Kondensatoreinheit eine relativ große Kondensatoreinheitenspannung bereitgestellt wird.

Das Verfahren kann so ausgestaltet sein, dass die Kondensatoreinheiten jeweils ein Gehäuse, insbesondere ein metallisches Gehäuse, aufweisen, das alle Kondensatorelemente der jeweiligen Kondensatoreinheit umgibt. Durch dieses Gehäuse wird zum einen eine ausreichende mechanische Stabilität der Kondensatoreinheiten sichergestellt. Zum anderen wird durch das Gehäuse eine elektrische Abschirmung der Kondensatorelemente der einzelnen Kondensatoreinheiten realisiert.

Das Verfahren kann auch so ablaufen, dass die Kondensatoreinheiten der Kondensatorbank in mindestens einer elektrischen Reihenschaltung und/oder in mindestens einer elektrischen Parallelschaltung angeordnet sind. Durch die elektrische Reihenschaltung der Kondensatoreinheiten lassen sich besonders hohe Spannungen realisieren; durch die elektrische Parallelschaltung der Kondensatoreinheiten lassen sich große Ströme realisieren. Durch eine geeignete Wahl von Parallelschaltungen und Reihenschaltungen lässt sich insbesondere eine technisch vorteilhafte Struktur der Kondensatorbank realisieren.

Das Verfahren kann auch so ausgestaltet sein, dass die Gruppen-Überwachungseinheiten jeweils im Wesentlichen auf dem elektrischen Potential der ihnen zugeordneten Gruppe von Kondensatoreinheiten angeordnet sind, und der Überwachungsempfänger im Wesentlichen auf Erdpotential angeordnet ist. Hierbei ist besonders vorteilhaft, dass für die Gruppen-Überwachungseinheiten nur vergleichsweise geringe Anforderungen bezüglich der elektrischen Isolierung und Spannungsfestigkeit bestehen, weil diese auf dem elektrischen Potential der ihnen zugeordneten Gruppe von Kondensatoreinheiten angeordnet sind. Dadurch können die Gruppen-Überwachungseinheiten kostengünstig realisiert werden. Beispielsweise ist eine Messung der Kondensatoreinheitenspannung und des Kondensatoreinheitenstroms durch die Gruppen-Überwachungseinheiten vergleichsweise einfach und kostengünstig möglich.

Das Verfahren kann auch so ausgestaltet sein, dass die Gruppen-Überwachungseinheiten jeweils mit elektrischer Energie versorgt werden, die aus der Gruppe von Kondensatoreinheiten ausgekoppelt wird, zu welcher die jeweilige Gruppen-Überwachungseinheit zugeordnet ist. Dadurch ist eine einfache und kostengünstige Versorgung der Gruppen-Überwachungseinheiten mit elektrischer Energie möglich. Insbesondere wird dadurch vermieden, dass zu jeder Gruppen-Überwachungseinheit elektrische Leitungen oder ähnliches zur Energieversorgung verlegt werden müssen, was zum einen teuer und aufwändig wäre, und zum anderen (insbesondere bei Hochspannungs-Kondensatorbänken) aufgrund der hohen auftretenden Spannungsunterschiede zwischen den Gruppen von Kondensatoreinheiten und Erdpotential problematisch wäre.

Das Verfahren kann auch so ablaufen, dass die elektrische Energie mittels eines Stromwandlers aus einem magnetischen Feld ausgekoppelt wird, das aufgrund des durch die Gruppe der Kondensatoreinheiten fließenden elektrischen Stroms gebildet wird. Mittels des Stromwandlers lässt sich besonders einfach die elektrische Energie zur Versorgung der Gruppen-Überwachungseinheiten auskoppeln. Diese Energie wird durch den durch die Gruppe von Kondensatoreinheiten fließenden Strom bereitgestellt.

Das Verfahren kann auch so ablaufen, dass von der Gruppen-Überwachungseinheit die Daten über den Ausfall des Kondensatorelements mittels eines Funksignals oder mittels eines Lichtwellenleiters zu dem Überwachungsempfänger übermittelt werden. Dadurch wird vorteilhafterweise die elektrische Isolierung zwischen den Gruppen-Überwachungseinheiten und dem auf Erdpotential angeordneten Überwachungsempfänger sichergestellt.

Das Verfahren kann auch so ablaufen, dass die Kondensatorbank mehrere elektrisch gegeneinander isolierte Etagen aufweist, auf denen jeweils mindestens eine der Gruppen von Kondensatoreinheiten und die zugeordnete Gruppen-Überwachungseinheit angeordnet sind. Vorteilhafterweise sind die Kondensatoreinheiten einer Gruppe jeweils auf einer Etage der Kondensatorbank angeordnet, so dass diese zum einen eine räumliche Einheit bilden. Zum anderen können die Gehäuse der Kondensatoreinheiten mit dem Etagenboden elektrisch verbunden sein, welcher für alle Kondensatoreinheiten der Gruppe ein einheitliches Bezugspotential (zum Beispiel für die Spannungsmessung, Strommessung und/oder Messwertverarbeitung) bildet.

Das Verfahren kann auch so ablaufen, dass bei elektrisch in einer Parallelschaltung angeordneten Kondensatoreinheiten einer Gruppe für die Kondensatoreinheiten der Parallelschaltung jeweils der Stromunterschied zwischen dem durch diese Kondensatoreinheit fließenden Strom und dem durchschnittlich durch die Kondensatoreinheiten fließenden Strom ermittelt wird,

- ein Mittelwert der Stromunterschiede der Kondensatoreinheiten ermittelt wird,
- für die Kondensatoreinheiten jeweils das Verhältnis aus dem Stromunterschied und dem Mittelwert gebildet wird,

- die zeitliche Änderung des Verhältnisses überwacht wird, und
- das Auftreten eines defekten Kondensatorelements bei der jeweiligen Kondensatoreinheit erkannt wird, wenn die zeitliche Änderung des Verhältnisses einen vorbestimmten ersten Schwellenwert überschreitet.

Das Verfahren kann auch so ablaufen, dass alternativ oder zusätzlich bei elektrisch in einer Reihenschaltung angeordneten Kondensatoreinheiten einer Gruppe die über den Kondensatoreinheiten jeweils auftretende Kondensatoreinheiten-Spannung ermittelt wird,

- jeweils der Spannungsunterschied zwischen den Kondensatoreinheiten-Spannungen und der durchschnittlichen Kondensatoreinheiten-Spannung der Kondensatoreinheiten der Reihenschaltung ermittelt wird,
- ein Mittelwert dieser Spannungsunterschiede ermittelt wird,
- für die Kondensatoreinheiten das Verhältnis aus dem jeweiligen Spannungsunterschied und dem Mittelwert gebildet wird,
- die zeitliche Änderung des Verhältnisses überwacht wird, und
- das Auftreten eines defekten Kondensatorelements bei der jeweiligen Kondensatoreinheit erkannt wird, wenn die zeitliche Änderung des Verhältnisses einen vorbestimmten zweiten Schwellenwert überschreitet.

Bei diesem Verfahren ist besonders vorteilhaft, dass bei der Parallelschaltung jeweils die Stromunterschiede zwischen dem durch die Kondensatoreinheiten fließenden Strom und dem durchschnittlichen durch die Kondensatoreinheiten fließenden Strom (beziehungsweise bei der Reihenschaltung die Spannungsunterschiede zwischen den Kondensatoreinheitenspannungen und der durchschnittlichen Kondensatoreinheitenspannung) ermittelt und im weiteren Verfahrensverlauf ausgewertet werden. Da die Kondensatoreinheiten in der Regel im Wesentlichen gleichartig aufgebaut sind, sind im intakten Zustand die Stromunterschiede (bzw. Spannungsunterschiede) sehr gering. Wenn nun (durch einen Ausfall eines Kondensatorelements) eine Veränderung der Stromunterschiede beziehungsweise der Spannungsunterschiede auftritt, dann ist diese Veränderung prozentual gesehen relativ groß und kann daher sicher erkannt werden. Weiterhin ist vorteilhaft, dass bei der Parallelschaltung jeweils das Verhältnis aus dem Stromunterschied und dem Mittelwert der Stromunterschiede der Kondensatoreinheiten (beziehungsweise bei der Reihenschaltung das Verhältnis aus dem Spannungsunterschied und dem Mittelwert der Spannungsunterschiede der Kondensatoreinheiten) ermittelt und überwacht wird. Durch diese Verhältnisbildung entfällt die Abhängigkeit von der absoluten Größe des Kondensatoreinheitenstroms beziehungsweise der Kondensatoreinheitenspannung. Dadurch funktioniert das Verfahren bei nahezu allen Betriebszuständen der Kondensatorbank, das heißt, es funktioniert beispielsweise bei Betriebsströmen von 60 %, 80 % oder 100 % des Nennstroms oder bei Betriebsspannungen von 60 %, 80 % oder 100 % der Nennspannung gleichartig zuverlässig.
Das Verfahren kann auch so ablaufen, dass die an einem Anschluss der Kondensatoreinheiten jeweils auftretende elektrische Spannung ermittelt wird mittels eines aus den Kondensatoreinheiten jeweils herausgeführten Stromsignals, welches proportional zu der an dem Anschluss der jeweiligen Kondensatoreinheit auftretenden Spannung ist und welches außerhalb der Kondensatoreinheit in ein Spannungssignals gewandelt wird. Durch die Stromsignale wird eine verbesserte Störungsunempfindlichkeit der Signalübertragung erreicht.
Offenbart wird weiterhin eine Anordnung mit einer Kondensatorbank (insbesondere mit einer Hochspannungs-Kondensatorbank), die eine Mehrzahl von Kondensatoreinheiten aufweist, wobei jede Kondensatoreinheit eine Mehrzahl von elektrischen Kondensatorelementen aufweist, und wobei die Kondensatoreinheiten in mehrere Gruppen von Kondensatoreinheiten aufgeteilt sind, und mit mehreren Gruppen-Überwachungseinheiten, wobei jeder Gruppe von Kondensatoreinheiten eine der Gruppen-Überwachungseinheiten zugeordnet ist, und mindestens eine der Gruppen-Überwachungseinheiten so ausgestaltet ist, dass sie die jeweilige Gruppe von Kondensatoreinheiten auf einen Ausfall eines Kondensatorelements in einer der Kondensatoreinheiten der Gruppe hin überwacht und bei einem Erkennen eines solchen Ausfalls eines Kondensatorelements Daten, die diesen Ausfall des Kondensatorelements beschreiben, zu einem Überwachungsempfänger übermittelt.
Die Anordnung kann so ausgestaltet sein, dass die in den Kondensatoreinheiten angeordneten Kondensatorelemente elektrisch parallel und/oder in Reihe geschaltet sind.
Die Anordnung kann auch so ausgestaltet sein, die Kondensatoreinheiten jeweils ein Gehäuse, insbesondere ein metallisches Gehäuse, aufweisen, das alle Kondensatorelemente der jeweiligen Kondensatoreinheit umgibt.
Die Anordnung kann so ausgestaltet sein, dass die Kondensatoreinheiten der Kondensatorbank in mindestens einer elektrischen Reihenschaltung und/oder in mindestens einer elektrischen Parallelschaltung angeordnet sind.
Die Anordnung kann auch so ausgestaltet sein, dass die Gruppen-Überwachungseinheiten jeweils im Wesentlichen auf dem elektrischen Potential der ihnen zugeordneten Gruppe von Kondensatoreinheiten angeordnet sind, und der Überwachungsempfänger im Wesentlichen auf Erdpotential angeordnet ist.
Die Anordnung kann auch so ausgestaltet sein, dass mindestens einer Gruppen-Überwachungseinheit eine Energieversorgungseinrichtung zugeordnet ist, die elektrische Energie zur Versorgung der Gruppen-Überwachungseinheit aus der Gruppe von Kondensatoreinheiten ausgekoppelt, zu welcher die jeweilige Gruppen-Überwachungseinheit zugeordnet ist.

Die Anordnung kann so ausgestaltet sein, dass die Gruppen-Überwachungseinheit einen Stromwandler aufweist, der die elektrische Energie aus einem magnetischen Feld ausgekoppelt, das aufgrund des durch die Gruppe der Kondensatoreinheiten fließenden elektrischen Stroms gebildet ist.

Die Anordnung kann auch so ausgestaltet sein, dass mindestens eine Gruppen-Überwachungseinheit eine drahtlose Übertragungseinheit (Funksender) aufweist, die die Daten über den Ausfall des Kondensatorelements mittels eines Funksignals zu dem Überwachungsempfänger übermittelt, und/oder - mindestens eine Gruppen-Überwachungseinheit mittels eines Lichtwellenleiters mit dem Überwachungsempfänger verbunden ist, um die Daten über den Ausfall des Kondensatorelements über den Lichtwellenleiter zu dem Überwachungsempfänger zu übermitteln.

Die Anordnung kann so ausgestaltet sein, dass die Kondensatorbank mehrere elektrisch gegeneinander isolierte Etagen aufweist, auf denen jeweils mindestens eine der Gruppen von Kondensatoreinheiten und die zugeordnete Gruppen-Überwachungseinheit angeordnet sind.

Die Anordnung kann auch so ausgestaltet sein, dass mindestens eine Gruppen-Überwachungseinheit so ausgestaltet ist, dass diese Gruppen-Überwachungseinheit

- bei elektrisch in einer Parallelschaltung angeordneten Kondensatoreinheiten einer Gruppe

  - für die Kondensatoreinheiten der Parallelschaltung jeweils den Stromunterschied zwischen dem durch diese Kondensatoreinheit fließenden Strom und dem durchschnittlich durch die Kondensatoreinheiten fließenden Strom ermittelt,
  - einen Mittelwert der Stromunterschiede der Kondensatoreinheiten ermittelt,
  - für die Kondensatoreinheiten jeweils das Verhältnis aus dem Stromunterschied und dem Mittelwert bildet,
  - die zeitliche Änderung des Verhältnisses überwacht, und
  - das Auftreten eines defekten Kondensatorelements bei der jeweiligen Kondensatoreinheit erkennt, wenn die zeitliche Änderung des Verhältnisses einen vorbestimmten ersten Schwellenwert überschreitet, und/oder

- bei elektrisch in einer Reihenschaltung angeordneten Kondensatoreinheiten einer Gruppe
- die über den Kondensatoreinheiten jeweils auftretende Kondensatoreinheiten-Spannung ermittelt,

- jeweils den Spannungsunterschied zwischen den Kondensatoreinheiten-Spannungen und der durchschnittlichen Kondensatoreinheiten-Spannung der Kondensatoreinheiten der Reihenschaltung ermittelt,
- einen Mittelwert dieser Spannungsunterschiede ermittelt,
- für die Kondensatoreinheiten das Verhältnis aus dem jeweiligen Spannungsunterschied und dem Mittelwert bildet,
- die zeitliche Änderung des Verhältnisses überwacht, und
- das Auftreten eines defekten Kondensatorelements bei

der jeweiligen Kondensatoreinheit erkennt, wenn die zeitliche Änderung des Verhältnisses einen vorbestimmten zweiten Schwellenwert überschreitet.

Die Anordnung kann auch so ausgestaltet sein, dass die Kondensatoreinheiten jeweils mit einem Strompfad versehen sind, der die jeweilige Kondensatoreinheit verlässt und zum Herausführen eines Stromsignals, welches proportional zu der an einem Anschluss der jeweiligen Kondensatoreinheit auftretenden Spannung ist, aus der jeweiligen Kondensatoreinheit eingerichtet ist.

Das beschriebene Verfahren und die beschriebene Anordnung weisen gleiche beziehungsweise gleichartige Vorteile auf.

Im Folgenden wird die Erfindung anhand von Ausführungsbeispielen näher erläutert. Gleiche Bezugszeichen verweisen dabei auf gleiche oder gleichwirkende Elemente. Dazu ist in

Figur 1    ein Ausführungsbeispiel einer Kondensatorbank mit drei Gruppen von Kondensatoreinheiten, in

Figur 2    ein Ausführungsbeispiel einer Kondensatoreinheit mit einzelnen Kondensatorelementen, in

Figur 3    ein Ausschnitt aus der Kondensatorbank mit einer Gruppe von elektrisch in Reihe geschalteten Kondensatoreinheiten, in

Figur 4    ein Ausschnitt aus einer weiteren Kondensatorbank mit einer Gruppe von elektrisch parallel geschalteten Kondensatoreinheiten, in

Figur 5    die Gruppe von elektrisch parallel geschalteten Kondensatoreinheiten mit einer Schaltung zum Ermitteln von Stromunterschieden, in

Figur 6    ein Ausführungsbeispiel einer Gruppe mit zwei elektrisch parallel geschalteten Kondensatoreinheiten, in

Figur 7     ein Ausführungsbeispiel einer Gruppe von Kondensatoreinheiten, die jeweils eine Signal-Stromquelle darstellen, in

Figur 8     ein Ausführungsbeispiel einer Kondensatoreinheit mit einer Widerstandsbeschaltung zur Spannungsmessung und in

Figur 9     ein Ausführungsbeispiel einer Gruppe von Kondensatoreinheiten mit einer Widerstandsbeschaltung zur Spannungsmessung

dargestellt.

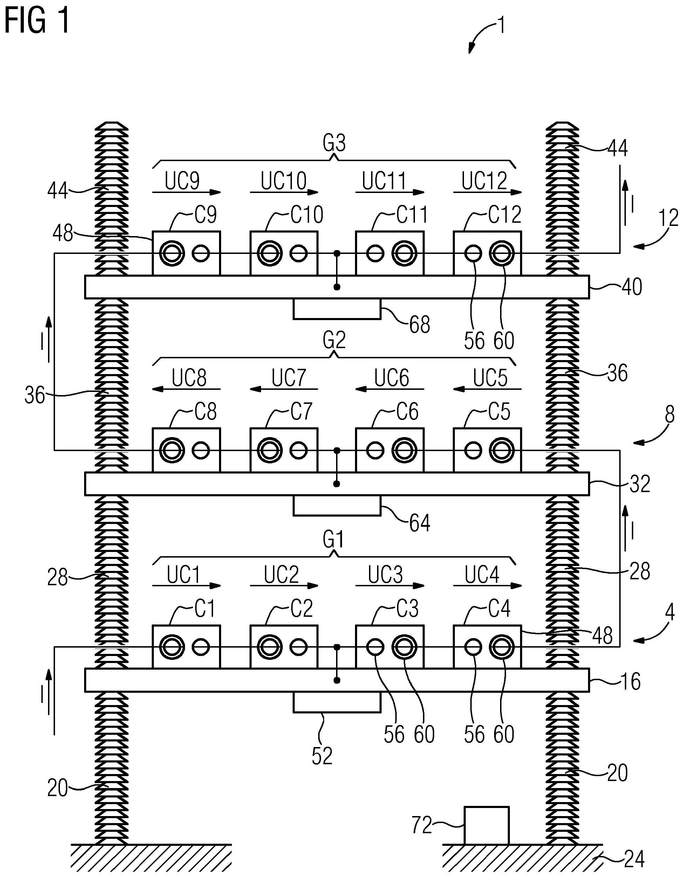

In Figur 1 ist ein Ausführungsbeispiel einer Kondensatorbank 1 dargestellt, welche beispielhaft als ein Kondensatorturm 1 ausgestaltet ist. Bei der Kondensatorbank 1 handelt es sich beispielhaft um eine Hochspannungs-Kondensatorbank. Diese Hochspannungs-Kondensatorbank weist eine Nennspannung von mehr als 50 kV auf, beispielsweise eine Nennspannung von 500 kV. Diese Kondensatorbank 1 weist eine erste Etage 4, eine zweite Etage 8 und eine dritte Etage 12 auf. Natürlich kann die Kondensatorbank 1 auch noch weitere Etagen aufweisen.

Die erste Etage 4 weist einen ersten Etagenboden 16 auf, welcher von ersten Stützisolatoren 20 getragen wird. Die ersten Stützisolatoren 20 stützen dabei die erste Etage 4 mechanisch und isolieren das elektrische Potential der ersten Etage 4 gegenüber Erdpotential 24. Auf der ersten Etage 4 ist mithilfe zweiter Stützisolatoren 28 ein zweiter Etagenboden 32 der zweiten Etage 8 abgestützt. In gleicher Weise ist auf der zweiten Etage 8 mittels dritter Stützisolatoren 36 ein dritter Etagenboden 40 der dritten Etage 12 aufgebaut. Auf dem dritten Etagenboden 40 sind vierte Stützisolatoren 44 angeordnet, auf denen eine weitere (nicht dargestellte) Etage des Kondensatorturms 1 gehaltert ist. Die Stützisolatoren gewährleisten die mechanische Stabilität des Kondensatorturms und isolieren die einzelnen Etagen elektrisch untereinander und gegenüber dem Erdpotential 24. Die einzelnen Etagen 4, 8, 12 der Kondensatorbank 1 sind also mittels der Stützisolatoren elektrisch gegeneinander isoliert. Die Stützisolatoren weisen dabei jeweils eine Vielzahl von Schirmen auf, um (zum Beispiel bei Betauung) die Kriechwege zu verlängern.

In der ersten Etage 4 ist eine erste Gruppe G1 von Kondensatoreinheiten angeordnet. Diese erste Gruppe von Kondensatoreinheiten G1 weist eine erste Kondensatoreinheit C1, eine zweite Kondensatoreinheit C2, eine dritte Kondensatoreinheit C3 und eine vierte Kondensatoreinheit C4 auf. Die vier Kondensatoreinheiten C1 - C4 sind elektrisch in einer Reihenschaltung angeordnet. Das bedeutet, dass der Kondensatoreinheitenstrom I durch alle Kondensatoreinheiten C1 - C4 der Gruppe G1 gleich groß ist. Über der ersten Kondensatoreinheit C1 fällt eine erste Kondensatoreinheiten-Spannung UC1 ab, über der zweiten Kondensatoreinheit C2 eine zweite Kondensatoreinheiten-Spannung UC2, über der dritten Kondensatoreinheit C3 eine dritte Kondensatoreinheiten-Spannung UC3 und über der vierten Kondensatoreinheit C4 eine vierte Kondensatoreinheiten-Spannung UC4. Die vier Kondensatoreinheiten C1 - C4 sind auf dem ersten Etagenboden 16 angeordnet.

Jede Kondensatoreinheit weist ein Gehäuse 48 auf. Die Kondensatoreinheiten C1 - C4 weisen also jeweils ein Gehäuse auf, das alle Kondensatorelemente der jeweiligen Kondensatoreinheit umgibt. Dieses Gehäuse 48 ist vorzugsweise ein elektrisch leitendes Gehäuse, insbesondere ein metallisches Gehäuse 48. Jede Kondensatoreinheit weist einen ersten Anschluss 56 (erster Pol 56) und einen zweiten Anschluss 60 (zweiter Pol 60) auf. Es handelt sich also um Kondensatoreinheiten mit jeweils zwei Anschlüssen beziehungsweise zwei Polen. Nach außen wirkt jede Kondensatoreinheit wie ein großer Kondensator. Jeder Anschluss kann insbesondere mittels einer Durchführung durch das Metallgehäuse der Kondensatoreinheit hindurchgeführt werden.

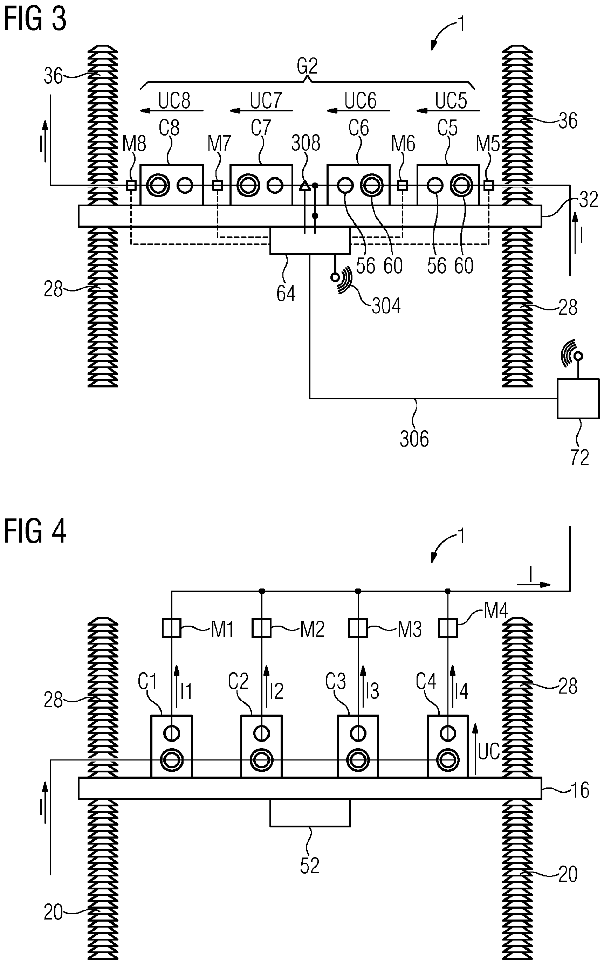

Das Gehäuse 48 der Kondensatoreinheiten C1 - C4 der ersten Gruppe ist jeweils elektrisch verbunden mit dem ersten Etagenboden 16, welcher vorzugsweise als ein metallischer Etagenboden (und damit elektrisch leitender Etagenboden 16) ausgestaltet ist. An dem ersten Etagenboden 16 ist eine erste Gruppen-Überwachungseinheit 52 angeordnet. In der Darstellung der Figur 1 ist diese erste Gruppen-Überwachungseinheit an der Unterseite des ersten Etagenbodens 16 angeordnet, dies ist aber nur beispielhaft zu verstehen. Natürlich kann die erste Gruppen-Überwachungseinheit 52 auch an der Oberseite des ersten Etagenbodens 16 angeordnet sein, beispielsweise neben den Kondensatoreinheiten C1 - C4. Die erste Gruppen-Überwachungseinheit 52 ist mittels nicht dargestellter Messleitungen mit nicht dargestellten Spannungssensoren an den Kondensatoreinheiten verbunden. Die Spannungssensoren sind mit den Anschlüssen 56 oder 60 der einzelnen Kondensatoreinheiten elektrisch verbunden, siehe auch Figur 3. Die erste Gruppen-Überwachungseinheit 52 ist daher in der Lage, die Spannungen an den Anschlüssen 56 oder 60 der einzelnen Kondensatoreinheiten zu messen (in Bezug auf das elektrische Potential des ersten Etagenbodens 16) und daher die Kondensatoreinheiten-Spannungen UC1 - UC4 zu ermitteln. Diejenigen Anschlüsse der Kondensatoreinheiten, an denen vorzugsweise die Spannungen in Bezug auf das Potential des ersten Etagenbodens 16 gemessen werden, sind dabei mit einem doppelten Kreis markiert.

In gleicher Weise ist auf der zweiten Etage 8 der Kondensatorbank 1 eine zweite Gruppe G2 an Kondensatoreinheiten C5, C6, C7 und C8 angeordnet. Dieser zweiten Gruppe G2 an Kondensatoreinheiten ist eine zweite Gruppen-Überwachungseinheit 64 zugeordnet. In gleicher Weise ist auch auf der dritten Etage 12 der Kondensatorbank 1 eine dritte Gruppe G3 an Kondensatoreinheiten C9, C10, C11 und C12 angeordnet. Dieser dritten Gruppe G3 ist eine dritte Gruppen-Überwachungseinheit 68 zugeordnet.

Die erste Gruppen-Überwachungseinheit 52 überwacht die Kondensatoreinheiten C1 - C4 der ersten Gruppe G1 auf einen Ausfall eines Kondensatorelements in einer der Kondensatoreinheiten C1 - C4 hin. Bei Erkennen eines solchen Ausfalls eines Kondensatorelements übermittelt die erste Gruppen-Überwachungseinheit 52 Daten, die diesen Ausfall des Kondensatorelements beschreiben, zu einem Überwachungsempfänger 72. Diese Daten können mittels eines Funksignals oder mittels eines Lichtwellenleiters zu dem Überwachungsempfänger 72 übermittelt werden. Der Überwachungsempfänger 72 verarbeitet diese den Ausfall des Kondensatorelements beschreibenden Daten entweder selbst oder leitet diese den Ausfall des Kondensatorelements beschreibenden Daten an eine Überwachungszentrale für die Kondensatorbank 1 weiter. Im letztgenannten Fall hat der Überwachungsempfänger 72 die Funktion eines Gateways. In den Daten ist ein Kennzeichen derjenigen Kondensatoreinheit C1, C2, C3 oder C4 enthalten, für die ein Ausfall eines Kondensatorelements erkannt worden ist. Dieses Kennzeichen kann beispielsweise eine Nummer (ID) der betroffenen Kondensatoreinheit sein oder ein anderes Kennzeichen. Somit ist bei dem Datenempfänger (also bei dem Überwachungsempfänger 72 oder bei der Überwachungszentrale) bekannt, in welcher Kondensatoreinheit der ersten Gruppe ein Kondensatorelement ausgefallen ist. Die zweite Gruppe G2 wird gleichartig mittels der zweiten Gruppen-Überwachungseinheit 64 überwacht; die dritte Gruppen-Überwachungseinheit 68 überwacht gleichartig die dritte Gruppe G3 an Kondensatoreinheiten.

Die Kondensatoreinheiten C1 - C12 der Kondensatorbank 1 sind also im Ausführungsbeispiel in drei verschiedene Gruppe G1, G2 und G3 aufgeteilt. Jeder dieser Gruppen G1, G2 und G3 ist eine eigene Gruppen-Überwachungseinheit 52, 64 beziehungsweise 68 zugeordnet; das heißt, die Kondensatoreinheiten jeder Gruppe werden von der ihnen exklusiv zugeordneten Gruppen-Überwachungseinheit auf den Ausfall eines Kondensatorelements hin überwacht. Dadurch wird ein verteiltes Überwachungsverfahren für die Kondensatorbank 1 beziehungsweise eine verteilte Überwachung der einzelnen Gruppen realisiert.

Die erste Gruppen-Überwachungseinheit 52 ist auf dem elektrischen Potential der ihr zugeordneten Gruppe G1 von Kondensatoreinheiten angeordnet. Der Überwachungsempfänger 72 ist auf Erdpotential 24 angeordnet. Einer Kondensatorbank kann auch mehr als ein Überwachungsempfänger 72 zugeordnet sein. So können einer Kondensatorbank beispielsweise zwei Überwachungsempfänger zugeordnet sein. Dabei kann beispielsweise der eine Überwachungsempfänger einer Teilmenge der Gruppen von Kondensatoreinheiten zugeordnet sein und der andere Überwachungsempfänger den restlichen Gruppen von Kondensatoreinheiten der Kondensatorbank zugeordnet ist.

Im Ausführungsbeispiel der Figur 1 sind die Kondensatoreinheiten C1 - C12 der Kondensatorbank 1 in einer elektrischen Reihenschaltung angeordnet. In einem anderen Ausführungsbeispiel können die Kondensatoreinheiten der Kondensatorbank aber auch in einer elektrischen Parallelschaltung angeordnet sein. In einem weiteren Ausführungsbeispiel einer Kondensatorbank können Reihenschaltungen von Kondensatoreinheiten und Parallelschaltungen von Kondensatoreinheiten vorhanden sein. Beispielsweise können jeweils mehrere Kondensatoreinheiten in einer Parallelschaltung geschaltet sein und diese Parallelschaltungen dann elektrisch in einer Reihenschaltung geschaltet sein. Im Ausführungsbeispiel der Figur 1 ist beispielhaft eine einfache Reihenschaltung von Kondensatoreinheiten gezeigt. In der Praxis wird oft eine sogenannte H-Schaltung der Kondensatoreinheiten verwendet, bei der insbesondere nur jeder zweite Etagenboden galvanisch an den Strompfad einer Reihenschaltung angebunden ist. Die übrigen Etagenböden sind galvanisch an den Strompfad einer zweiten Reihenschaltung der H-Schaltung angebunden.

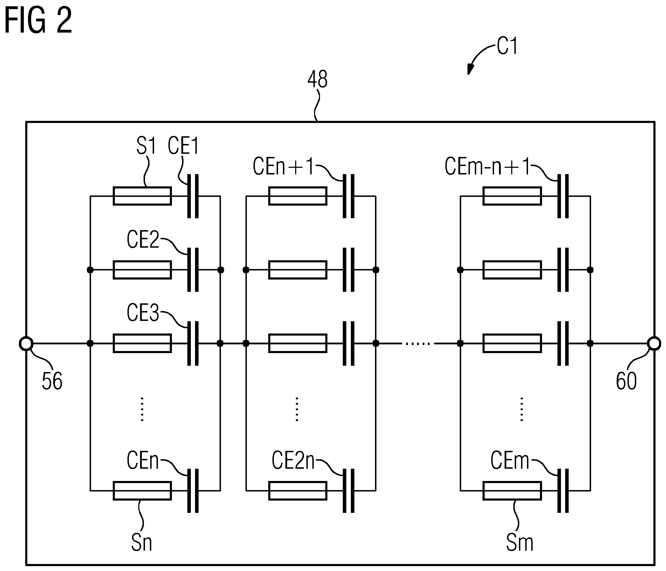

In Figur 2 ist ein Ausführungsbeispiel einer Kondensatoreinheit dargestellt am Beispiel der ersten Kondensatoreinheit C1. Die anderen Kondensatoreinheiten C2 - C12 können gleichartig zu der ersten Kondensatoreinheit C1 aufgebaut sein. Die erste Kondensatoreinheit C1 weist m Kondensatorelemente CE auf, diese Kondensatorelemente CE stellen jeweils Einzelkondensatoren dar. Die Kondensatorelemente werden auch als Kondensatorwickel bezeichnet. Jedem Kondensatorelement CE kann optional eine Sicherung S zugeordnet sein, welche bei einem Kurzschluss des zugehörigen Kondensatorelements durchbrennt. In einer Kondensatoreinheit können sowohl Kondensatorelemente mit Sicherung als auch Kondensatorelemente ohne Sicherung angeordnet sein. Kondensatorelemente mit Sicherung werden auch als gesicherte Kondensatorelemente bezeichnet; Kondensatorelemente ohne Sicherung werden auch als ungesicherte Kondensatorelemente bezeichnet.

Das unten beschriebene Verfahren zur verteilte Überwachung der Kondensatoreinheiten ist im Falle von gesicherten Kondensatorelementen besonders vorteilhaft, da bei Ausfall eines einzelnen Kondensatorelements die übrigen intakten Kondensatorelemente weiter in Betrieb bleiben. Die auftretende kleine Änderung der Gesamtkapazität ist mit herkömmlichen Überwachungsmethoden der gesamten Kondensatorbank jedoch kaum erkennbar.

Im Ausführungsbeispiel sind jeweils n Kondensatorelemente in einer Parallelschaltung angeordnet; die Parallelschaltungen sind elektrisch in Reihe geschaltet und bilden eine Reihenschaltung. Ein Ende dieser Reihenschaltung ist mit dem ersten Anschluss 56 der Kondensatoreinheit elektrisch verbunden, das andere Ende der Reihenschaltung ist mit dem zweiten Anschluss 60 der Kondensatoreinheit elektrisch verbunden.

Wenn also zum Beispiel das dritte Kondensatorelement CE3 der ersten Kondensatoreinheit C1 ausfällt, dann erkennt die erste Gruppen-Überwachungseinheit 52 diesen Ausfall und sendet mit den den Ausfall beschreibenden Daten eine Kennung der ersten Kondensatoreinheit C1 an den Überwachungsempfänger 72.

In Figur 3 ist beispielhaft ein Ausschnitt aus der Kondensatorbank 1 dargestellt. Dieser Ausschnitt zeigt die zweite Gruppe G2 der Kondensatoreinheiten C5 - C8. Die Kondensatoreinheiten C5 - C8 sind elektrisch in Reihe geschaltet. Die dieser Gruppe von Kondensatoreinheiten C5 - C8 zugeordnete zweite Gruppen-Überwachungseinheit 64 sendet Daten über den Ausfall eines Kondensatorelements der Kondensatoreinheiten C5 - C8 der Gruppe G2 mittels eines Funksignals 304 an den Überwachungsempfänger 72. Dazu weist die zweite Gruppen-Überwachungseinheit 64 einen Funksender (drahtlose Übertragungseinheit) auf; der Überwachungsempfänger 72 weist einen Funkempfänger auf. Alternativ oder zusätzlich können die Daten auch mittels eines Lichtwellenleiters 306 (oder mittels einer anderen drahtlosen Datenübertragungstechnik) von der zweiten Gruppen-Überwachungseinheit 64 zu dem Überwachungsempfänger 72 übermittelt werden.

Jeweils einem Anschluss einer Kondensatoreinheit ist ein Spannungssensor zugeordnet. So ist dem zweiten Anschluss 60 der fünften Kondensatoreinheit C5 ein erster Spannungssensor M5 zugeordnet; dem zweiten Anschluss 60 der sechsten Kondensatoreinheit C6 ist ein zweiter Spannungssensor M6 zugeordnet. Mittels des ersten Spannungssensors M5 kann das elektrische Potential des zweiten Anschlusses 60 der fünften Kondensatoreinheit C5 gemessen werden. Mittels des zweiten Spannungssensors M6 kann das elektrische Potential des zweiten Anschlusses 60 der sechsten Kondensatoreinheit C6 gemessen werden (welches identisch ist zu dem elektrischen Potential des ersten Anschlusses 56 der fünften Kondensatoreinheit C5).

Der Verbindungspunkt zwischen der sechsten Kondensatoreinheit C6 und der siebten Kondensatoreinheit C7 ist elektrisch verbunden mit dem zweiten Etagenboden 32, dieses elektrische Potential des Verbindungspunktes wird ebenfalls zu der Gruppen-Überwachungseinheit 64 weitergeleitet. Dieses elektrische Potential des Verbindungspunktes dient als Bezugspotential für die Spannungsmessung. Weiterhin sind ein dritter Spannungssensor M7 und ein vierter Spannungssensor M8 an den Anschlüssen der siebten Kondensatoreinheit C7 und der achten Kondensatoreinheit C8 angeordnet. Mittels dieser Spannungssensoren M5 - M8 können die elektrischen Potentiale an den Anschlüssen der einzelnen Kondensatoreinheiten ermittelt werden. Aus diesen Potentialen können die den Kondensatoreinheiten jeweils zugehörigen Kondensatoreinheiten-Spannungen UC5 - UC8 berechnet werden. Die zweite Gruppen-Überwachungseinheit 64 ist mittels (strichliert dargestellter) Messleitungen mit den Spannungssensoren M5 - M8 verbunden. Die Kondensatoreinheiten der Gruppe G2 sind bezüglich des Verbindungspunktes spiegelsymmetrisch angeordnet.

Beispielsweise misst der erste Spannungssensor M5 den elektrischen Potentialunterschied zwischen dem zweiten Anschlusses 60 der fünften Kondensatoreinheit C5 und dem Potential des zweiten Etagenbodens 32. Dieser Messwert Umess5 entspricht der Summe aus der Kondensatoreinheiten-Spannung UC5 der fünften Kondensatoreinheit C5 und der Kondensatoreinheiten-Spannung UC6 der sechsten Kondensatoreinheit C6: Umess5 = UC5 + UC6. Der sechste Spannungssensor M6 misst den elektrischen Potentialunterschied zwischen dem zweiten Anschlusses 60 der sechsten Kondensatoreinheit C6 und dem Potential des zweiten Etagenbodens 32: Umess6 = UC6. Die Kondensatoreinheiten-Spannung UC5 der fünften Kondensatoreinheit C5 ergibt sich dann gemäß UC5 = Umess5 - Umess6.

Bei dieser Art der Bestimmung der Kondensatoreinheiten-Spannungen ist folgender Effekt zu beachten: Wenn in der sechsten Kondensatoreinheit C6 ein Kondensatorelement ausfällt, dann bewirkt dies eine Änderung in der direkt gemessenen Spannung UC6 und in der berechneten Spannung UC5. Wenn also scheinbar in der fünften Kondensatoreinheit C5 und in der sechsten Kondensatoreinheit C6 gleichzeitig jeweils ein Kondensatorelement ausfällt, so liegt in Wirklichkeit nur ein Ausfall in der sechsten Kondensatoreinheit C6 vor. Dies kann bei der Auswertung der Daten automatisch berücksichtigt werden. Es ist aber (ggf. mit einer aufwändigeren Spannungsmesstechnik) prinzipiell auch möglich, alle Kondensatoreinheiten-Spannungen direkt zu messen. Dann tritt der beschriebene Effekt nicht auf.

Die auf der Etage montierten Kondensatoreinheiten einer Gruppe weisen an ihren leitfähigen Gehäusen alle das gleiche elektrische Potential auf. Dies wird dadurch sichergestellt, dass der Etagenboden ebenfalls elektrisch leitfähig ist. Der Etagenboden kann beispielsweise aus Metall bestehen. Die Spannungen werden insbesondere mit Bezug auf das elektrische Potential des Etagenbodens gemessen. Dadurch ist es möglich, alle Stromsensoren oder Spannungssensoren einer Gruppe relativ problemlos mit der Gruppen-Überwachungseinheit zu verbinden. Die Messleitungen brauchen beispielsweise nicht für besonders große Spannungsunterschiede ausgelegt sein. Durch das leitfähige Gehäuse wird eine gute elektromagnetische Abschirmung der Kondensatoreinheiten erreicht.

Am Verbindungspunkt zwischen der sechsten Kondensatoreinheit C6 und der siebten Kondensatoreinheit C7 ist weiterhin ein Energieauskoppelbauteil 308 angeordnet. Mittels dieses Energieauskoppelbauteils 308 wird elektrische Energie aus der Gruppe G2 der Kondensatoreinheiten C5 - C8 ausgekoppelt. Diese elektrische Energie dient zur Versorgung der zweiten Gruppen-Überwachungseinheit 64. Das Energieauskoppelbauteil 308 stellt also eine Energieversorgungseinrichtung 308 für die zweite Gruppen-Überwachungseinheit 64 dar. Das Energieauskoppelbauteil 308 ist über eine Energieversorgungsleitung elektrisch mit der zweiten Gruppen-Überwachungseinheit 64 verbunden.

Bei dem Energieauskoppelbauteil kann es sich insbesondere um einen Stromwandler 308 handeln. Dieser koppelt elektrische Energie (zum Beispiel in Form von Wechselstrom) aus dem magnetischen Feld aus, welches sich aufgrund des durch die Gruppe G2 der Kondensatoreinheiten C5 - C8 fließenden elektrischen Stroms I bildet.

Der mittels des Stromwandlers aus dem magnetischen Feld ausgekoppelte Wechselstrom (Sekundärstrom) wird in üblicher Art und Weise mittels eines Gleichrichters gleichgerichtet. Die Gleichspannung wird stabilisiert und es kann zusätzlich eine Vorrichtung zur Verringerung von Spannungsspitzen vorgesehen sein, beispielsweise ein Überstromableiter.

Bei der in Figur 3 dargestellten Reihenschaltung an Kondensatoreinheiten ist der durch diese Reihenschaltung fließende elektrische Strom I bei allen Kondensatoreinheiten gleich groß. Daher werden die über den Kondensatoreinheiten auftretenden Kondensatoreinheiten-Spannungen UC5 - UC8 ermittelt und ausgewertet, um einen Ausfall eines Kondensatorelements zu erkennen.

Die Darstellung der Figur 3 soll nicht so verstanden werden, dass die Spannungssensoren M5 bis M8 notwendigerweise frei hängende Spannungssensoren sind, welche jeweils ein eigenes Gerät darstellen. Im Hinblick auf die Kosten der Isolation eines Spannungssensors ist es vielmehr vorteilhaft, wenn der Spannungssensor in die jeweilige Kondensatoreinheit integriert ist. Der Spannungssensor kann also in das Gehäuse der jeweiligen Kondensatoreinheit integriert sein.

In Figur 4 ist ein weiteres Ausführungsbeispiel einer Gruppe von Kondensatoreinheiten C1 - C4 dargestellt, wobei diese Kondensatoreinheiten C1 - C4 elektrisch parallel geschaltet sind. Daher liegt über allen vier Kondensatoreinheiten C1 - C4 jeweils die gleiche Kondensatoreinheiten-Spannung UC an. Der durch die elektrischen Kondensatoreinheiten fließende elektrische Strom I1 - I4 kann aber jeweils unterschiedlich groß sein. Daher wird mittels Stromsensoren M1 - M4 der jeweils durch die Kondensatoreinheiten fließende Strom I1 - I4 gemessen. Entsprechende Strommesswerte werden zu der zugehörigen Gruppen-Überwachungseinheit 52 übertragen und in dieser ausgewertet. Die Stromsensoren M1 - M4 brauchen dabei nicht unbedingt an der in Figur 4 angedeuteten Stelle angeordnet zu sein. Insbesondere ist es isolationstechnisch sinnvoll, wenn die Stromsensoren M1 - M4 (Stromwandler M1 - M4) nahe am elektrischen Potential des Etagenbodens 16 angeordnet sind. Beispielsweise können die Stromsensoren M1 - M4 mit Vorteil an denjenigen Anschlüssen der Kondensatoreinheiten angeordnet sein, die dem ersten Etagenboden 16 zugewandt sind. Diese Anschlüsse sind in Figur 4 mittels eines doppelten Kreises markiert.

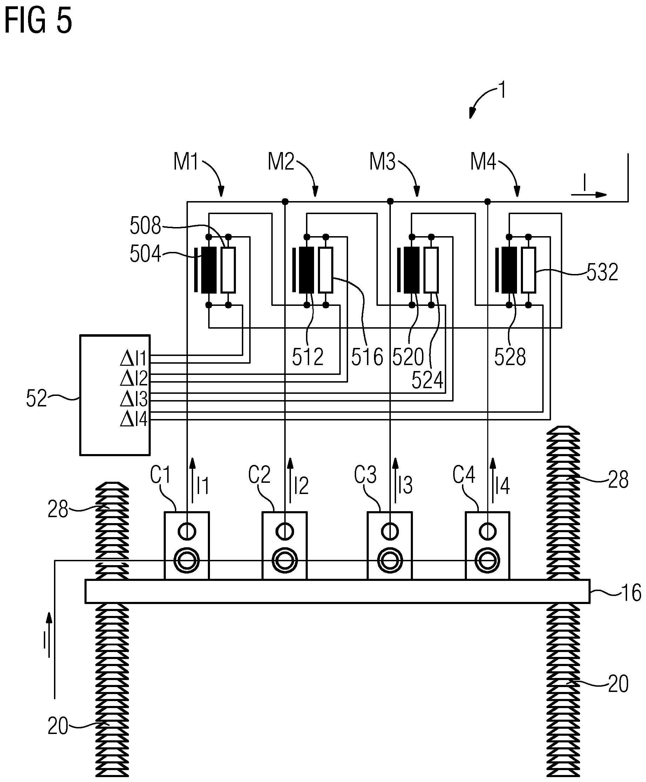

In Figur 5 ist die Ausgestaltung der Strommessung mittels der Stromsensoren M1 - M4 genauer dargestellt. Der erste Stromsensor M1 ist als ein erster Stromwandler 504 ausgestaltet. Parallel zu dem ersten Stromsensor M1 (genauer gesagt parallel zu der Sekundärwicklung des ersten Stromsensors M1) ist ein erster Widerstand 508 geschaltet. Ebenso ist der zweite Stromsensor M2 als ein zweiter Stromwandler 512 mit parallel geschaltetem Widerstand 516 ausgestaltet. In gleicher Art und Weise ist der dritte Stromsensor M3 als ein dritter Stromwandler 520 mit parallel geschaltetem dritten Widerstand 524 ausgestaltet, und der vierte Stromsensor M4 ist als ein vierter Stromwandler 528 mit parallel geschaltetem vierten Widerstand 532 ausgestaltet. Die Widerstände 508, 516, 524 und 532 können auch als Messwiderstände oder Shuntwiderstände bezeichnet werden.

Die Sekundärwicklungen der Stromwandler 504, 512, 520 und 528 sind elektrisch in Reihe geschaltet, wobei die Reihenschaltung zu einer geschlossenen Masche verbunden ist. Dadurch fließt durch die Sekundärwicklungen der vier Stromwandler 504, 512, 520 und 528 ein mittlerer Strom Iav, welcher im Wesentlichen proportional ist zu dem mittleren durch die vier Kondensatoreinheiten C1 - C4 fließenden Strom. Wenn sich der durch eine Kondensatoreinheit fließende Strom von dem mittleren durch die Kondensatoreinheiten fließenden Strom Iav unterscheidet (beispielsweise weil in dieser Kondensatoreinheit ein Kondensatorelement ausgefallen ist), dann fließt der diesem unterscheidenden Strom entsprechende Anteil des in der Masche fließenden Stroms durch den Widerstand (der parallel zu dem dieser Kondensatoreinheit zugeordneten Stromwandler geschaltet ist) und erzeugt an diesem Widerstand ein Spannungssignal. Dieses Spannungssignal ist proportional zu dem Stromunterschied $\Delta$In zwischen dem durch die entsprechende Kondensatoreinheit fließenden Strom In und dem durchschnittlich durch die Kondensatoreinheiten C1 - C4 fließenden Strom Iav (Durchschnittsstrom Iav). Auf diese Art und Weise wird mittels der in Figur 5 dargestellten Schaltung auf analogem Wege für die vier Kondensatoreinheiten C1 - C4 der Gruppe jeweils der Stromunterschied $\Delta$I1, $\Delta$I2, $\Delta$I3 beziehungsweise $\Delta$I4 ermittelt. Das ist der Stromunterschied zwischen dem durch die jeweilige Kondensatoreinheit fließenden Strom I1, I2, I3 beziehungsweise I4 und dem durchschnittlich durch die Kondensatoreinheiten fließenden Strom Iav.

Für den durchschnittlich durch die Kondensatoreinheiten fließenden Strom Iav gilt:

$$\mathrm{Iav} = \frac{1}{\mathrm{x}} \sum_{\mathrm{n}=1}^{\mathrm{x}} \mathrm{In}$$

wobei x die Anzahl der Kondensatoreinheiten der Gruppe ist. Hier gilt

$$\mathrm{Iav} = \frac{\mathrm{I1} + \mathrm{I2} + \mathrm{I3} + \mathrm{I4}}{4}$$

Die Stromunterschiede $\Delta$In werden also vorteilhafterweise dadurch ermittelt, dass die Sekundärwicklungen der Stromwandler in einer gemeinsamen Masche angeordnet sind, so dass durch alle Sekundärwicklungen der gleiche Strom fließt. Dadurch lassen sich die Stromunterschiede ΔIn besonders einfach ermitteln. Aber natürlich ist auch eine andere Art der Ermittlung der Stromunterschiede ΔIn möglich, zum Beispiel eine Messung der durch die Kondensatoreinheiten jeweils fließenden Ströme I1, I2, I3 und I4 und anschließende Berechnung der Stromunterschiede ΔIn.

Messwerte dieser Stromunterschiede ΔIn werden zu der ersten Gruppenüberwachungseinheit 52 übertragen und dort weiterverarbeitet. Dazu wird ein Mittelwert ΔIav dieser Stromunterschiede ΔI1, ΔI2, ΔI3 und ΔI4 ermittelt:

$$\Delta Iav = \frac{1}{x} \sum_{n=1}^{x} \Delta In$$

wobei x die Anzahl der Kondensatoreinheiten der Gruppe ist.

Hier gilt

$$\Delta Iav = \frac{\Delta I1 + \Delta I2 + \Delta I3 + \Delta I4}{4}$$

Danach wird für jede Kondensatoreinheit jeweils das Verhältnis aus dem Stromunterschied ΔIn und dem Mittelwert ΔIav gebildet. Die zeitliche Änderung dieses Verhältnisses wird daraufhin überwacht, ob die zeitliche Änderung einen vorbestimmten ersten Schwellenwert überschreitet:

$$\frac{d\left(\frac{\Delta In}{\Delta Iav}\right)}{dt} > SW1$$

Wenn diese zeitliche Änderung des Verhältnisses den vorbestimmten ersten Schwellwert SW1 überschreitet, dann wird erkannt, dass bei der jeweiligen Kondensatoreinheit Cn ein defektes Kondensatorelement vorliegt. Daraufhin sendet die erste Gruppen-Überwachungseinheit 52 Daten mit Informationen über die entsprechende Kondensatoreinheit Cn zu dem Überwachungsempfänger 72.

Dabei ist besonders vorteilhaft, dass das Verhältnis $\frac{\Delta In}{\Delta Iav}$ auf das Auftreten einer den ersten Schwellenwert SW1 überschreitenden zeitlichen Änderung (d.h. auf das Auftreten einer großen zeitlichen Änderung) hin überwacht wird. Durch Nutzung dieses Verhältnisses sind die Stromunterschiede ΔIn auf den Mittelwert ΔIav der Stromunterschiede aller Kondensatoreinheiten der Gruppe bezogen. Dadurch führt selbst ein kleiner Stromunterschied bei dem durch eine Kondensatoreinheit fließenden Strom zu einer deutlichen Veränderung des Verhältnisses $\frac{\Delta In}{\Delta Iav}$. Diese Änderung des Verhältnisses $\frac{\Delta In}{\Delta Iav}$ ist dabei so groß, dass sie sich deutlich vom Rauschen oder von eingekoppelten Störsignalen unterscheidet. Somit ist eine sichere und zuverlässige Erkennung des Ausfalls eines einzelnen Kondensatorelements möglich.

Im Falle einer Reihenschaltung von Kondensatoreinheiten in einer Gruppe findet die Erkennung eines ausgefallenen Kondensatorelements folgendermaßen statt:

In einem ersten Schritt werden die über den Kondensatoreinheiten jeweils auftretenden Kondensatoreinheiten-Spannungen UC1, UC2, UC3 und UC4 ermittelt. Dies erfolgt, wie oben im Zusammenhang mit Figur 3 beschrieben, durch Messung der an den Anschlüssen der Kondensatoreinheiten auftretenden elektrischen Potentiale gegenüber dem elektrischen Potential des Etagenbodens (Rack).

Danach wird die durchschnittliche Kondensatoreinheiten-Spannung UCav der Kondensatoreinheiten der Reihenschaltung ermittelt gemäß

$$UCav = \frac{1}{x} \sum_{n=1}^{x} UCn$$

wobei x die Anzahl der Kondensatoreinheiten der Gruppe ist.

Hier gilt

$$UCav = \frac{UC1 + UC2 + UC3 + UC4}{4}$$

Danach wird für alle Kondensatoreinheiten-Spannungen jeweils der Spannungsunterschied ΔUCn zwischen der jeweiligen Kondensatoreinheiten-Spannung UCn und der durchschnittlichen Kondensatoreinheiten-Spannung UCav der Kondensatoreinheiten der Reihenschaltung ermittelt gemäß

$$\Delta UCn = UCn - UCav$$

Im nächsten Schritt wird ein Mittelwert ΔUav dieser Spannungsunterschiede ΔUcn ermittelt, gemäß

$$\Delta Uav = \frac{1}{x} \sum_{n=1}^{x} \Delta UCn$$

wobei x die Anzahl der Kondensatoreinheiten der Gruppe

ist.

Hier gilt

$$\Delta Uav = \frac{\Delta UC1 + \Delta UC2 + \Delta UC3 + \Delta UC4}{4}$$

Danach wird für die Kondensatoreinheiten jeweils das Verhältnis aus dem jeweiligen Spannungsunterschied ΔUCn und dem Mittelwert ΔUav gebildet. Dieses Verhältnis ΔUCn/ΔUav wird daraufhin überwacht, ob die zeitliche Änderung des Verhältnisses einen vorbestimmten zweiten Schwellenwert überschreitet:

$$\frac{d\left(\frac{\Delta UCn}{\Delta Uav}\right)}{dt} > SW2$$

Wenn die zeitliche Änderung des Verhältnisse ΔUCn/ΔUav den vorbestimmten zweiten Schwellenwert SW2 überschreitet, dann wird das Auftreten eines defekten Kondensatorelements bei der jeweiligen Kondensatoreinheit Cn erkannt und entsprechende Daten werden von der der Gruppe zugehörigen Gruppen-Überwachungseinheit zu dem Überwachungsempfänger 72 übertragen.

Bei der Reihenschaltung von Kondensatoreinheiten werden also die über den einzelnen Kondensatoreinheiten auftretenden Kondensatoreinheiten-Spannungen und die Spannungsunterschiede zwischen den Kondensatoreinheiten-Spannungen ermittelt. Zwar ist die Änderung der Kondensatoreinheiten-Spannung aufgrund eines Ausfalls eines einzelnen Kondensatorelements sehr klein, aber aufgrund der Betrachtung der Spannungsunterschiede und der Bildung des Verhältnisses treten deutliche zeitliche Änderungen bei dem genannten Verhältnis auf und können sicher erkannt werden.

Das Verfahren wird fortlaufend durchgeführt, um eine fortlaufende Überwachung der Kondensatoreinheiten der Gruppe sicherzustellen.

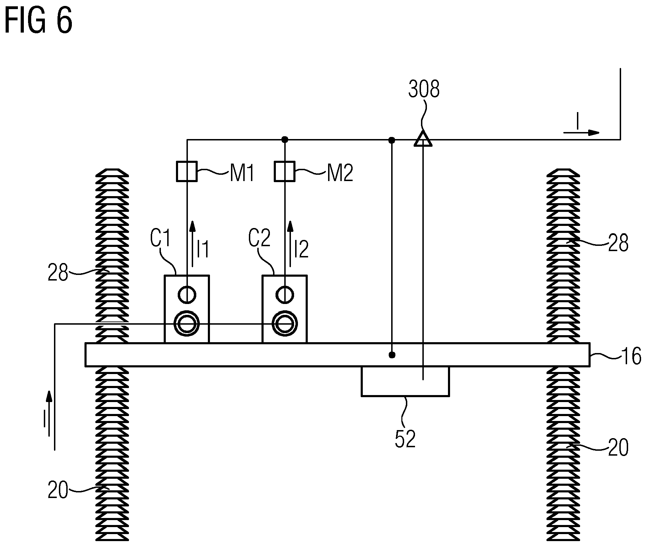

In Figur 6 ist ein weiteres Beispiel des Verfahrens und der Anordnung zur Überwachung einer Kondensatorbank dargestellt. Dabei weist eine Gruppe lediglich zwei Kondensatoreinheiten C1 und C2 auf. Durch die erste Kondensatoreinheit C1 fließt der erste Strom I1; durch die zweite Kondensatoreinheit C2 fließt der zweite Strom I2. Als erster Schritt wird der Stromunterschied ΔI zwischen dem ersten Strom I1 und dem zweiten Strom I2 ermittelt: ΔI = I1 - I2.

Im Folgenden wird davon ausgegangen, dass ein gesichertes Kondensatorelement ausfällt. Wenn in der zweiten Kondensatoreinheit C2 ein gesichertes Kondensatorelement ausfällt (zum Beispiel aufgrund einer Unterbrechung der in Reihe geschalteten Sicherung), dann wird der Strom I2 sprunghaft kleiner: I2' < I2. Je nach Anzahl und Verschaltung der Kondensatorelemente in der zweiten Kondensatoreinheit C2 ändert sich der Strom I2 jedoch nur um einen kleinen Prozentbetrag, beispielsweise I2' = 0,98 I2. Nun wird erneut der Stromunterschied gebildet: ΔI' = I1 - I2' > ΔI. Allgemein gilt: Wenn ΔI' größer ist als ΔI, dann ist in der zweiten Kondensatoreinheit C2 ein Kondensatorelement ausgefallen. Wenn ΔI' kleiner ist als ΔI, dann ist in der ersten Kondensatoreinheit C1 ein Kondensatorelement ausgefallen. Bei diesem Bespiel mit lediglich zwei Kondensatoreinheiten mit internen Kondensatorelement-Sicherungen ist das Verfahren deutlich vereinfacht gegenüber dem oben dargestellten allgemeinen Verfahren mit mehr als 2 Kondensatoreinheiten. In der Regel ist die Anzahl der Kondensatoreinheiten pro Gruppe größer als 2.

Bei ungesicherten Kondensatorelementen ist die Änderung von Kapazität und Strom in der Kondensatoreinheit genau umgekehrt: Ein defektes ungesicherten Kondensatorelement schließt sämtliche parallel geschalteten Kondensatorelemente kurz und die effektive Kapazität und der Strom der Kondensatoreinheit vergrößert sich dadurch. Die Änderung des Stroms der Kondensatoreinheit ist wesentlich größer und einfacher zu detektieren als bei der intern gesicherten Kondensatoreinheit.

Sowohl bei ungesicherten Kondensatorelementen als auch bei gesicherten Kondensatorelementen ist die genaue Lokalisierung / Identifizierung der defekten Kondensatoreinheit von größtem Interesse, damit zum Beispiel bei Häufung von Kurzschlüssen / Ausfällen innerhalb einer Kondensatoreinheit die Kondensatorbank rechtzeitig außer Betrieb genommen werden kann.

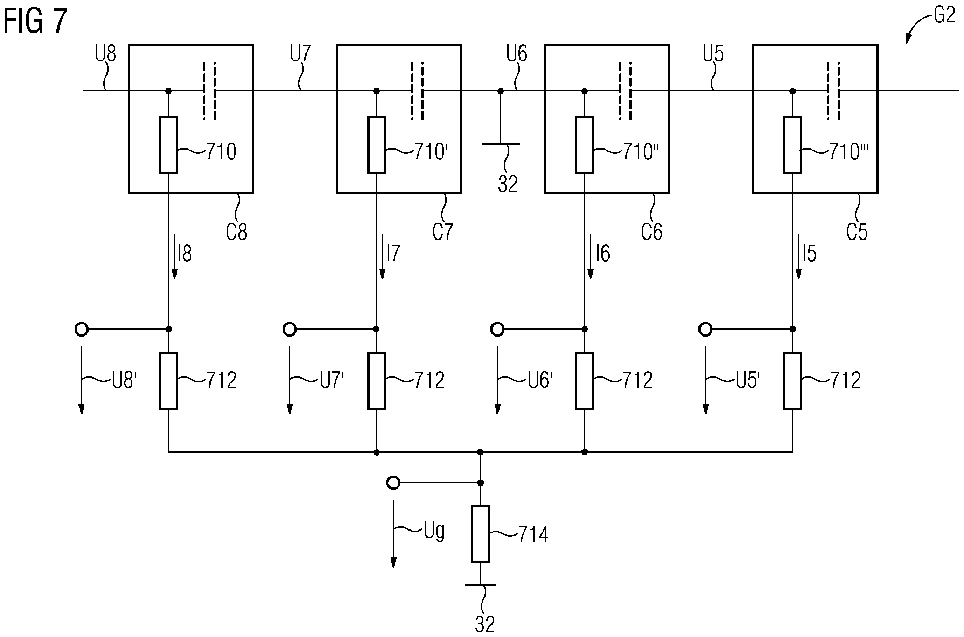

In Figur 7 ist ein weiteres Ausführungsbeispiel mit der zweiten Gruppe G2 der Kondensatoreinheiten C5 - C8 dargestellt. Die an diesen Kondensatoreinheiten jeweils anliegende Spannung wird mittels eines Stromsignals I5 bis I8 ermittelt; die anliegende Spannung wird in ein Stromsignal I5 bis I8 umgewandelt. Dazu ist in jeder Kondensatoreinheit jeweils ein Anschluss mit einem ersten elektrischen Widerstand 710 versehen. Beispielsweise ist ein Anschluss der Kondensatoreinheit C8 mit einem der ersten elektrischen Widerstände 710 versehen. Durch diesen ersten elektrischen Widerstand 710 fließt das Stromsignal I8 über einen Strompfad aus der Kondensatoreinheit C8 hinaus und gelangt zu einem zweiten Widerstand 712. Dazu ist in dem Gehäuse der Kondensatoreinheit eine Niederspannungs-Durchführung vorgesehen. Die aufgrund des Stromsignals I8 an dem zweiten Widerstand 712 abfallende Spannung U8' ist proportional zu der am Anschluss der Kondensatoreinheit auftretenden Spannung U8. Diese Spannung U8' wird der zweiten Gruppenüberwachungseinheit 64 zugeführt und dort ausgewertet. Vorteilhafterweise ist dabei das Verhältnis des ersten Widerstands 710 zu dem zweiten Widerstand 712 so gewählt, dass die Spannung U8' viel kleiner ist als die Spannung U8. Beispielsweise kann die Spannung U8' in der Größenordnung von ca. 10 V liegen, während die Spannung U8 einige kV beträgt (beispielsweise 20 kV). Die Übertragung der Stromsignale zum zweiten Widerstand 712 (der am Eingang der Gruppenüberwachungseinheit angeordnet ist) ist vorteilhafterweise unempfindlicher gegenüber elektrischen Störungen im Vergleich zur Verwendung eines Spannungssignals. Die Kondensatoreinheiten sind also jeweils mit einem Strompfad versehen, der die jeweilige Kondensatoreinheit verlässt und zum Herausführen des Stromsignals I8, I7, I6 bzw. I5 aus der jeweiligen Kondensatoreinheit eingerichtet ist. Optional kann an einem die einzelnen Stromsignale vereinigenden Widerstand 714 eine Spannung Ug abgegriffen werden, die proportional ist zu der durchschnittlich an den Kondensatoreinheiten anliegenden Spannung.

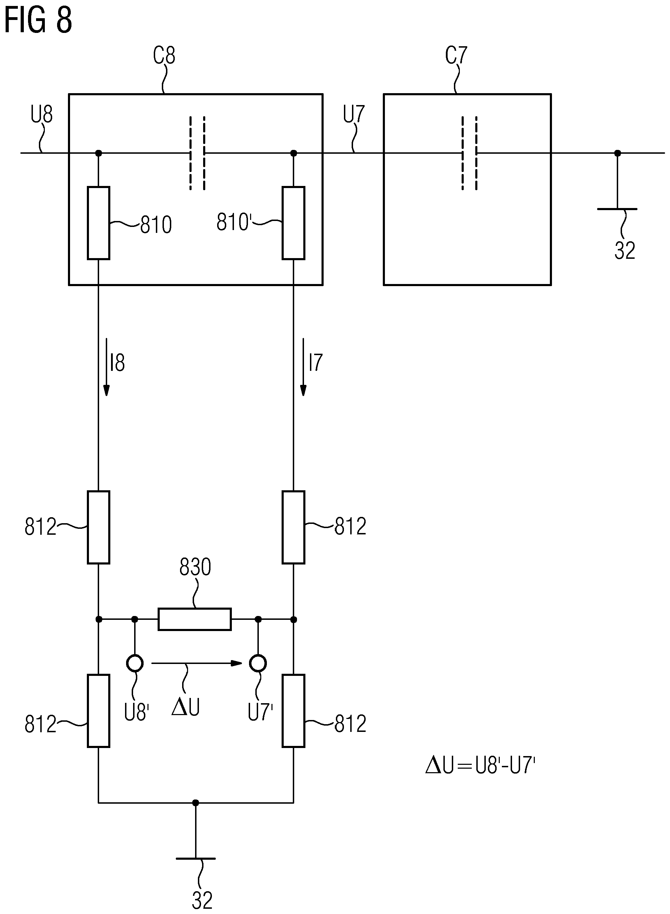

In Figur 8 ist beispielhaft eine weitere Möglichkeit der Ermittlung der an einer Kondensatoreinheit anliegenden Spannung dargestellt, am Beispiel der Kondensatoreinheit C8. Ähnlich wie bei Figur 7 wird an den Anschlüssen der Kondensatoreinheit C8 jeweils ein Stromsignals I7 und I8 über jeweils einen Strompfad aus der Kondensatoreinheit C8 herausgeführt. Diese Stromsignale I7, I8 werden zu einer Spannungs-Messbrücke geleitet. Die Spannungs-Messbrücke weist im Ausführungsbeispiel vier Widerstände 812 sowie einen Widerstand 830 auf. Die Spannungs-Messbrücke bildet eine H-Schaltung. Der Widerstand 830 (Querwiderstand 830, Messwiderstand 830) bildet einen Querzweig der Messbrücke. An dem Widerstand 830 kann eine Spannung ΔU abgegriffen werden, die proportional ist zu der über der Kondensatoreinheit C8 anliegenden Spannung. Dies setzt voraus, dass die Widerstände 810 und 810' gleich groß sind, beispielsweise jeweils 200 Megaohm.

Optional können die Widerstände 810 und 810' jedoch auch jeweils an die Spannungswerte U8 und U7 an den Anschlüssen der Kondensatoreinheit C8 angepasst werden, so dass die Ströme I8 und I7 in etwa gleich groß sind. Die Spannung ΔU ist dann im Wesentlichen gleich Null, wenn die Spannung über der Kondensatoreinheit C8 gleich der Spannung über der angrenzenden Kondensatoreinheit C7 ist. In diesem Fall wird an dem Querwiderstand nur dann eine Spannung auftreten, wenn sich die Spannung über der Kondensatoreinheit C8 oder die Spannung über der Kondensatoreinheit C7 ändert (aufgrund eines Auftretens eines Fehlers in einem Kondensatorelement).

Bei kleinen Spannungsänderungen in einer Kondensatoreinheit wird daher die Spannung am Querwiderstand eine starke Änderung zeigen.

Die Messbrücke stellt eine Widerstandsbeschaltung zur Spannungsmessung dar. Durch die Messbrücke wird vorteilhafterweise die absolute Größe der Spannungen U7 und U8 ausgeblendet und die Änderungen in den Spannungen U7 oder U8 werden deutlich verstärkt und dadurch einfach messbar. Die für die Parallelschaltung von Kondensatoreinheiten angegebenen Vorteile (insbesondere Unabhängigkeit vom jeweiligen Betriebsstrom der Kondensatorbank durch Verhältnisbildung zum Mittelwert und die Langzeitkompensation von (zum Beispiel temperaturbedingten) Schwankungen in der Gruppenüberwachungseinheit) gelten auch hier.

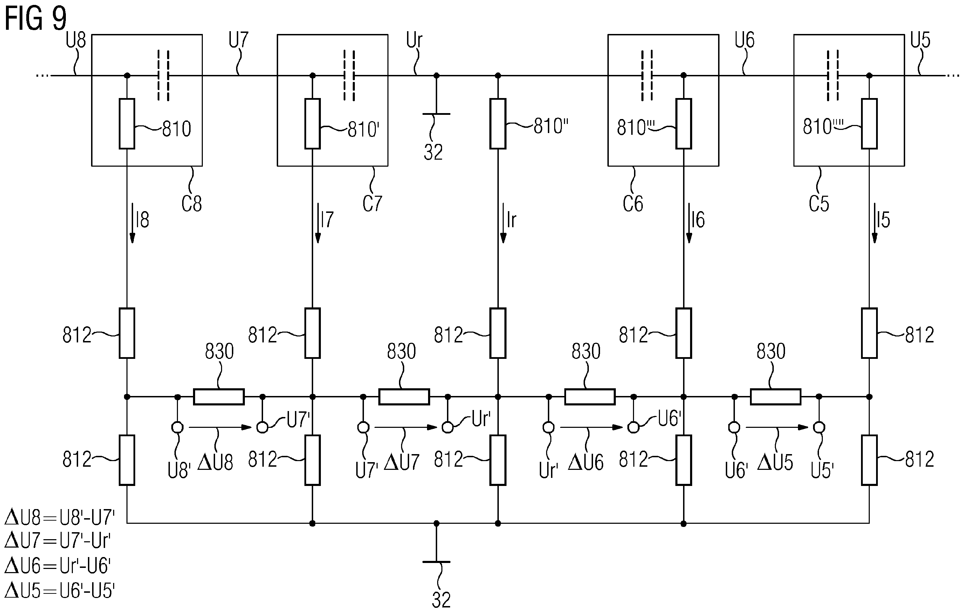

In Figur 9 ist ein weiteres Ausführungsbeispiel zur Ermittlung der an den Kondensatoreinheiten anliegenden Spannungen dargestellt, am Beispiel der vier elektrisch in Reihe geschalteten Kondensatoreinheiten C5 bis C8. Diese Kondensatoreinheiten sind mit einer Mehrzahl von Messbrücken verbunden, wobei diese Messbrücken in einem Netzwerk angeordnet sind. An den Widerständen 830 kann jeweils eine Spannung ΔU abgegriffen werden, die sich stark ändert, sobald in einer Kondensatoreinheit ein Fehler auftritt. Die Anbindung des Verbindungspunktes zwischen den Kondensatoreinheiten C6 und C7 an das Rack-Potential Ur (elektrisches Potential Ur des Etagenbodens 32) ist optional. Insbesondere bei fehlender Anbindung hat der Strom Ir Relevanz für die Messung.

Es wurde eine Anordnung mit einer Kondensatorbank und mit mehreren Gruppen-Überwachungseinheiten beschrieben sowie ein Verfahren zum Überwachen der Kondensatorbank auf den Ausfall von Kondensatorelementen hin.

Die Gruppen-Überwachungseinheit kann auch als ein Sensorknoten bezeichnet werden, da die Gruppen-Überwachungseinheit mit den an den einzelnen Kondensatoreinheiten angeordneten Strom- oder Spannungssensoren in Verbindung steht und die von diesen stammenden Strom- bzw. Spannungsmesswerte erfasst und weiterverarbeitet.

Die Gruppen-Überwachungseinheit weist im Ausführungsbeispiel eine Messwerteerfassungseinheit, eine Verarbeitungseinheit (Messwerteverarbeitungseinheit, Logikschaltung) und eine drahtlose Übertragungseinheit (Funksender) auf. Jedes gemessene Strom- oder Spannungssignal wird zur Messwerteerfassungseinheit übertragen. Die Strom- oder Spannungssignale sämtlicher Kondensatoreinheiten der Gruppe werden zu der dieser Gruppe zugeordneten Gruppen-Überwachungseinheit übertragen und dort weiterverarbeitet. In der Verarbeitungseinheit findet die Weiterverarbeitung der Messwerte statt. In dieser Verarbeitungseinheit werden die Mittelwerte gebildet, die Verhältnisse gebildet und die zeitlichen Änderungen der Verhältnisse überwacht. Anhand einer plötzlichen Änderung eines Verhältnisses (aufgrund eines plötzlich geringer werdenden Stroms durch eine Kondensatoreinheit) wird erkannt, dass ein Kondensatorelement der Kondensatoreinheit ausgefallen ist. Die drahtlose Übertragungseinheit sendet dann das Ergebnis der Verarbeitungseinheit an den Überwachungsempfänger auf Erdpotential. Durch die drahtlose Übertragung der Daten werden Probleme durch Potentialunterschiede zwischen der Gruppen-Überwachungseinheit und dem Überwachungsempfänger vermieden.

Wenn ein Kondensatorelement ohne Sicherung ausfallbedingt kurzgeschlossen ist, sind gleichzeitig alle zu diesem Kondensatorelement parallel geschalteten Kondensatorelemente kurzgeschlossen, so dass der Strom durch die jeweilige Kondensatoreinheit stark ansteigt. Solche Ausfälle von Kondensatoreinheiten ohne Sicherung können also noch einfacher mittels des Verfahrens und der Anordnung erkannt werden.

Beschrieben wurden ein Verfahren und eine Anordnung, bei denen Spannungsunterschiede bzw. Stromunterschiede ermittelt und ausgewertet werden. Die Ermittlung der Spannungs- und/oder Stromunterschiede kann auf analoge Art mittels einer festverdrahteten Messschaltung erfolgen. Die Auswertung der Spannungsunterschiede bzw. Stromunterschiede erfolgt in einer Gruppen-Überwachungseinheit, welche der jeweiligen Gruppe von Kondensatoreinheiten zugeordnet ist. Wenn eine schnelle zeitliche Änderung der ermittelten Strom- oder Spannungsverhältnisse festgestellt wird, dann wird erkannt, dass ein Kondensatorelement bei der jeweiligen Kondensatoreinheit ausgefallen ist. In diesem Fall werden Daten mit Informationen über die betroffene Kondensatoreinheit von der Gruppen-Überwachungseinheit (zum Beispiel per Funksignal oder per Lichtwellenleiter) zu einem auf Erdpotential angeordneten Überwachungsempfänger übermittelt.

Das beschriebene Verfahren wertet bei der Parallelschaltung von Kondensatoreinheiten Stromunterschiede und bei der Reihenschaltung von Kondensatoreinheiten Spannungsunterschiede aus. Es wird jeweils das Verhältnis aus einem Stromunterschied und dem Mittelwert der Stromunterschiede bzw. das Verhältnis aus einem Spannungsunterschied und dem Mittelwert der Spannungsunterschiede gebildet. Dadurch wird der Absolutwert von Strom oder Spannung irrelevant und die Genauigkeit der Messung wird deutlich vergrößert.

Die Wahrscheinlichkeit, dass in mehreren Kondensatoreinheiten einer Gruppe gleichzeitig Kondensatorelemente ausfallen und dadurch keine charakteristischen Spannungs- bzw. Stromunterschiede entstehen, ist sehr gering und kann vernachlässigt werden. Langsame Änderungen der ermittelten Verhältnisse (also solche, die kleiner sind als der erste Schwellenwert oder der zweite Schwellenwert) können auch ohne Ausfall eines Kondensatorelements auftreten, beispielsweise durch langsame Temperaturdrift aufgrund von Sonneneinstrahlung oder thermischer Erwärmung der Kondensatorbank. Aufgrund solcher langsamen zeitlichen Veränderungen des Verhältnisses wird nicht der Ausfall eines Kondensatorelements erkannt. Derartige langsame Änderungen können von der Auswerteschaltung kompensiert werden.

Das beschriebene Verfahren und die beschriebene Anordnung weisen eine Reihe von Vorteilen auf:

- Es ist nicht notwendig, an jedem einzelnen Kondensatorelement einer Kondensatoreinheit Messungen vorzunehmen (also Messungen innerhalb des Gehäuses einer Kondensatoreinheit). Es ist also nicht notwendig, die einzelnen durch die Kondensatorelemente fließenden Einzelströme (oder die an den Kondensatorelementen auftretenden Einzelspannungen) zu bestimmen. Derartig aufwändige und damit teure Messungen werden vermieden. Es ist nämlich ausreichend, wenn die Ströme oder Spannungen der Kondensatoreinheiten außerhalb der Kondensatoreinheiten (an den Anschlüssen der Kondensatoreinheiten) ermittelt werden. Die Ströme oder Spannungen werden vorzugsweise mit Bezug auf das elektrische Potential der einzelnen Etagen der Kondensatorbank gemessen (Rack-Potential).

- Es werden keine kostenintensiven Hochpräzisionsmessungen benötigt, weil aufgrund der Bildung des Verhältnisses aus dem Strom- oder Spannungsunterschied und dem Mittelwert bei Ausfall auch nur eines einzelnen Kondensatorelements eine vergleichsweise große zeitliche Änderung des Verhältnisses auftritt. Die Gruppen-Überwachungseinheiten und die Strom- und Spannungssensoren können daher relativ einfach und robust realisiert werden. Dies ist insbesondere deshalb ein Vorteil, weil die Gruppen-Überwachungseinheiten und die Strom- und Spannungssensoren auf Hochspannungsniveau auf den einzelnen Etagen der Kondensatorbank angeordnet sind.

Insbesondere bei parallel geschalteten Kondensatoreinheiten, welche Kondensatorelemente mit Sicherung aufweisen, wäre es nur sehr schwer möglich, durch eine Strommessung, Spannungsmessung oder Kapazitätsmessung einen Ausfall eines einzigen Kondensatorelements zu erkennen. Daher werden bei dem beschriebenen Verfahren Stromunterschiede zwischen den durch die Kondensatoreinheiten fließenden Strömen ermittelt und diese Stromunterschiede ins Verhältnis gesetzt zu einem mittleren Stromunterschied. Dadurch ist der benötigte Messbereich deutlich geringer. Mit anderen Worten führt der Ausfall auch nur eines Kondensatorelements zu einer deutlichen zeitlichen Änderung des Verhältnisses aus dem Stromunterschied und dem Mittelwert der Stromunterschiede. Als Beispiel kann der Ausfall eines einzigen Kondensatorelements dazu führen, dass die Kapazität der Kondensatoreinheit und damit der durch die Kondensatoreinheit fließende Strom leicht verringert ist, beispielsweise um 1,5 %. Diese geringe Stromveränderung wäre messtechnisch relativ schwierig zu bestimmen, insbesondere unter den rauen Bedingungen einer Hochspannungsanlage in der Industrie. Bei dem beschriebenen Verfahren reicht jedoch (aufgrund der Bestimmung der Stromunterschiede und des Verhältnisses) eine Messung mit viel geringerer Genauigkeit aus, um den Ausfall eines einzigen Kondensatorelements zu erkennen. Diesen Effekt kann man als Vergrößerungsglaseffekt bei Messungen bezeichnen. Dieser Effekt tritt auf, weil nicht die Absolutwerte von Strom und Spannung ausgewertet werden, sondern Unterschiedswerte ins Verhältnis zueinander gesetzt werden.

Aus der Größe der zeitlichen Änderung des Verhältnisses kann sogar erkannt werden, ob ein Kondensatorelement ausgefallen ist, oder ob gleichzeitig zwei oder mehrere Kondensatorelemente in einer Kondensatoreinheit ausgefallen sind. Der gleichzeitige Ausfall von zwei oder mehr Kondensatorelementen in einer Kondensatoreinheit ist allerdings sehr unwahrscheinlich.

Die Ergebnisse des beschriebenen Verfahrens und der Anordnung (das heißt, die Erkenntnisse über ausgefallene Kondensatorelemente) können optional überprüft werden durch Vergleich mit Ergebnissen einer herkömmlichen Überwachung der Kondensatorbank. Damit kann die Plausibilität der Ergebnisse überprüft werden.

Manchmal kann der Fall auftreten, dass bei einem mit einer Sicherung versehenen Kondensatorelement die Sicherung nicht vollständig durchbrennt, sondern dass über der teilweise durchgebrannten Sicherung periodische Überschläge auftreten. Die daraus folgende periodische Änderung des Stroms bzw. der Spannung kann optional ebenfalls von der jeweiligen Gruppen-Überwachungseinheit erkannt werden. So kann auch in diesem Fall erkannt werden, dass das jeweilige Kondensatorelement defekt ist.

**Patentansprüche**

1. Verfahren zum Überwachen einer Kondensatorbank (1), die eine Mehrzahl von Kondensatoreinheiten (C1 ... C12) aufweist, wobei jede Kondensatoreinheit eine Mehrzahl von elektrischen Kondensatorelementen (CE1 ... CEm) aufweist, und wobei die Kondensatoreinheiten (C1 ... C12) in mehrere Gruppen von Kondensatoreinheiten (C1 ... C4, C5 ... C8, C9 ... C12) aufgeteilt sind und jeder Gruppe von Kondensatoreinheiten (C1 ... C4, C5 ... C8, C9 ... C12) eine Gruppen-Überwachungseinheit (52, 64, 68) zugeordnet ist,
   wobei bei dem Verfahren

   - jede Gruppe von Kondensatoreinheiten (C1 ... C4) mittels der zugeordneten Gruppen-Überwachungseinheit (52) auf einen Ausfall eines Kondensatorelements (CE1 ... CEm) in einer der Kondensatoreinheiten (C1 ... C4) der Gruppe hin überwacht wird, und
   - bei einem Erkennen eines solchen Ausfalls eines Kondensatorelements (CE3) Daten, die diesen Ausfall des Kondensatorelements (CE3) beschreiben, von der Gruppen-Überwachungseinheit (52) zu einem Überwachungsempfänger (72) übermittelt werden.

2. Verfahren nach Anspruch 1,
   **dadurch gekennzeichnet, dass**

   - Daten über die Kondensatoreinheit (C1) mit dem ausgefallenen Kondensatorelement (CE3) von der Gruppen-Überwachungseinheit (52) zu dem Überwachungsempfänger (72) übermittelt werden.

3. Verfahren nach Anspruch 1 oder 2,
   **dadurch gekennzeichnet, dass**

   - die in den Kondensatoreinheiten (C1 ... C12) angeordneten Kondensatorelemente elektrisch parallel und/oder in Reihe geschaltet sind.

4. Verfahren nach einem der vorhergehenden Ansprüche,
   **dadurch gekennzeichnet, dass**

   - die Kondensatoreinheiten (C1 ... C12) jeweils ein Gehäuse (48), insbesondere ein metallisches Gehäuse (48), aufweisen, das alle Kondensatorelemente der jeweiligen Kondensatoreinheit umgibt.

5. Verfahren nach einem der vorhergehenden Ansprüche,
   **dadurch gekennzeichnet, dass**

   - die Kondensatoreinheiten (C1 ... C12) der Kondensatorbank in mindestens einer elektrischen Reihenschaltung und/oder in mindestens einer elektrischen Parallelschaltung angeordnet sind.

6. Verfahren nach einem der vorhergehenden Ansprüche,
   **dadurch gekennzeichnet, dass**

   - die Gruppen-Überwachungseinheiten (52) jeweils im Wesentlichen auf dem elektrischen Potential der ihnen zugeordneten Gruppe von Kondensatoreinheiten (C1 ... C4) angeordnet sind, und der Überwachungsempfänger (72) im Wesentlichen auf Erdpotential (24) angeordnet ist.

7. Verfahren nach einem der vorhergehenden Ansprüche,
   **dadurch gekennzeichnet, dass**

   - die Gruppen-Überwachungseinheiten (64) jeweils mit elektrischer Energie versorgt werden, die aus der Gruppe von Kondensatoreinheiten (C5 ... C8) ausgekoppelt wird, zu welcher die jeweilige Gruppen-Überwachungseinheit (64) zugeordnet ist.

8. Verfahren nach Anspruch 7,
   **dadurch gekennzeichnet, dass**

   - die elektrische Energie mittels eines Stromwandlers (308) aus einem magnetischen Feld ausgekoppelt wird, das aufgrund des durch die Gruppe der Kondensatoreinheiten (C5 ... C8) fließenden elektrischen Stroms (I) gebildet wird.

**9.** Verfahren nach einem der vorhergehenden Ansprüche,
**dadurch gekennzeichnet, dass**

- von der Gruppen-Überwachungseinheit (52) die Daten über den Ausfall des Kondensatorelements (CE3) mittels eines Funksignals (304) und/oder mittels eines Lichtwellenleiters (306) zu dem Überwachungsempfänger (72) übermittelt werden.

**10.** Verfahren nach einem der vorhergehenden Ansprüche,
**dadurch gekennzeichnet, dass**

- die Kondensatorbank (1) mehrere elektrisch gegeneinander isolierte Etagen (4, 8, 12) aufweist, auf denen jeweils mindestens eine der Gruppen von Kondensatoreinheiten (C1 ... C4) und die zugeordnete Gruppen-Überwachungseinheit (52) angeordnet sind.

**11.** Verfahren nach einem der vorhergehenden Ansprüche,
**dadurch gekennzeichnet, dass**

- bei elektrisch in einer Parallelschaltung angeordneten Kondensatoreinheiten (C1, C2, C3, C4) einer Gruppe

- für die Kondensatoreinheiten (C1, C2, C3, C4) der Parallelschaltung jeweils der Stromunterschied ($\Delta$In) zwischen dem durch diese Kondensatoreinheit fließenden Strom (In) und dem durchschnittlich durch die Kondensatoreinheiten fließenden Strom (Iav) ermittelt wird,
- ein Mittelwert ($\Delta$Iav) der Stromunterschiede ($\Delta$In) der Kondensatoreinheiten ermittelt wird,
- für die Kondensatoreinheiten jeweils das Verhältnis aus dem Stromunterschied ($\Delta$In) und dem Mittelwert ($\Delta$Iav) gebildet wird,
- die zeitliche Änderung des Verhältnisses ($\Delta$In/$\Delta$Iav) überwacht wird, und
- das Auftreten eines defekten Kondensatorelements (CE3) bei der jeweiligen Kondensatoreinheit (C1) erkannt wird, wenn die zeitliche Änderung des Verhältnisses ($\Delta$In/$\Delta$Iav) einen vorbestimmten ersten Schwellenwert (SW1) überschreitet, und/oder

- bei elektrisch in einer Reihenschaltung angeordneten Kondensatoreinheiten (C1, C2, C3, C4) einer Gruppe
- die über den Kondensatoreinheiten jeweils auftretende Kondensatoreinheiten-Spannung (UC1, UC2, UC3, UC4) ermittelt wird,
- jeweils der Spannungsunterschied ($\Delta$UCn) zwischen den Kondensatoreinheiten-Spannungen (UCn) und der durchschnittlichen Kondensatoreinheiten-Spannung (UCav) der Kondensatoreinheiten der Reihenschaltung ermittelt wird,
- ein Mittelwert ($\Delta$Uav) dieser Spannungsunterschiede ($\Delta$UCn) ermittelt wird,
- für die Kondensatoreinheiten das Verhältnis aus dem jeweiligen Spannungsunterschied ($\Delta$UCn) und dem Mittelwert ($\Delta$Uav) gebildet wird,
- die zeitliche Änderung des Verhältnisses ($\Delta$UCn/$\Delta$Uav) überwacht wird, und
- das Auftreten eines defekten Kondensatorelements (CE3) bei der jeweiligen Kondensatoreinheit (C1) erkannt wird, wenn die zeitliche Änderung des Verhältnisses ($\Delta$UCn/$\Delta$Uav) einen vorbestimmten zweiten Schwellenwert (SW2) überschreitet.

**12.** Verfahren nach Anspruch 11,
**dadurch gekennzeichnet, dass**

- die an einem Anschluss der Kondensatoreinheiten jeweils auftretende elektrische Spannung ermittelt wird mittels eines aus den Kondensatoreinheiten jeweils herausgeführten Stromsignals (I8, I7, I6, I5), welches proportional zu der an dem Anschluss der jeweiligen Kondensatoreinheit auftretenden Spannung ist und welches außerhalb der Kondensatoreinheit in ein Spannungssignals gewandelt wird.

**13.** Anordnung

- mit einer Kondensatorbank (1), die eine Mehrzahl von Kondensatoreinheiten (C1 ... C12) aufweist, wobei jede Kondensatoreinheit eine Mehrzahl von elektrischen Kondensatorelementen (CE1 ... CEm) aufweist, und wobei die Kondensatoreinheiten (C1 ... C12) in mehrere Gruppen von Kondensatoreinheiten (C1 ... C4, C5 ... C8, C9 ... C12) aufgeteilt sind, und
- mit mehreren Gruppen-Überwachungseinheiten (52, 64, 68), wobei jeder Gruppe von Kondensatoreinheiten (C1 ... C4, C5 ... C8, C9 ... C12) eine der Gruppen-Überwachungseinheiten (52, 64, 68) zugeordnet ist, und mindestens eine der Gruppen-Überwachungseinheiten (52) so ausgestaltet ist, dass sie die jeweilige Gruppe von Kondensatoreinheiten (C1 ... C4) auf einen Ausfall eines Kondensatorelements (CE1 ... CEm) in einer der Kondensatoreinheiten (C1 ... C4) der Gruppe hin überwacht und bei einem Erkennen eines solchen Ausfalls eines Kondensatorelements (CE3) Daten, die diesen Ausfall des Kondensatorelements (CE3) beschreiben, zu einem Überwachungsempfänger (72) übermittelt.

14. Anordnung nach Anspruch 13,
    **dadurch gekenzeichnet**, dass

    - die in den Kondensatoreinheiten (C1 ... C12) angeordneten Kondensatorelemente elektrisch parallel und/oder in Reihe geschaltet sind.

15. Anordnung nach Anspruch 13 oder 14,
    **dadurch gekennzeichnet, dass**

    - die Kondensatoreinheiten (C1 ... C12) jeweils ein Gehäuse (48), insbesondere ein metallisches Gehäuse (48), aufweisen, das alle Kondensatorelemente der jeweiligen Kondensatoreinheit umgibt.

16. Anordnung nach einem der Ansprüche 13 bis 15,
    **dadurch gekennzeichnet, dass**

    - die Kondensatoreinheiten (C1 ... C12) der Kondensatorbank in mindestens einer elektrischen Reihenschaltung und/oder in mindestens einer elektrischen Parallelschaltung angeordnet sind.

17. Anordnung nach einem der Ansprüche 13 bis 16,
    **dadurch gekennzeichnet, dass**

    - die Gruppen-Überwachungseinheiten (52) jeweils im Wesentlichen auf dem elektrischen Potential der ihnen zugeordneten Gruppe von Kondensatoreinheiten (C1 ... C4) angeordnet sind, und der Überwachungsempfänger (72) im Wesentlichen auf Erdpotential (24) angeordnet ist.

18. Anordnung nach einem der Ansprüche 13 bis 17,
    **dadurch gekennzeichnet, dass**

    - mindestens einer Gruppen-Überwachungseinheit (64) eine Energieversorgungseinrichtung (308) zugeordnet ist, die elektrische Energie zur Versorgung der Gruppen-Überwachungseinheit (64) aus der Gruppe von Kondensatoreinheiten (C5 ... C8) auskoppelt zu welcher die jeweilige Gruppen-Überwachungseinheit (64) zugeordnet ist.

19. Anordnung nach Anspruch 18,
    **dadurch gekennzeichnet, dass**

    - die Gruppen-Überwachungseinheit einen Stromwandler (308) aufweist, der die elektrische Energie aus einem magnetischen Feld auskoppelt das aufgrund des durch die Gruppe der Kondensatoreinheiten (C5 ... C8) fließenden elektrischen Stroms (I) gebildet ist.

20. Anordnung nach einem der Ansprüche 13 bis 19,
    **dadurch gekennzeichnet, dass**

    - mindestens eine Gruppen-Überwachungseinheit (64) eine drahtlose Übertragungseinheit aufweist, die die Daten über den Ausfall des Kondensatorelements (CE3) mittels eines Funksignals (304) zu dem Überwachungsempfänger (72) übermittelt, und/oder
    - mindestens eine Gruppen-Überwachungseinheit (64) mittels eines Lichtwellenleiters (306) mit dem Überwachungsempfänger (72) verbunden ist, um die Daten über den Ausfall des Kondensatorelements über den Lichtwellenleiter (306) zu dem Überwachungsempfänger (72) zu übermitteln.

21. Anordnung nach einem der Ansprüche 13 bis 20,
    **dadurch gekennzeichnet, dass**

    - die Kondensatorbank (1) mehrere elektrisch gegeneinander isolierte Etagen (4, 8, 12) aufweist, auf denen jeweils mindestens eine der Gruppen von Kondensatoreinheiten (C1 ... C4) und die zugeordnete Gruppen-Überwachungseinheit (52) angeordnet sind.

22. Anordnung nach einem der Ansprüche 13 bis 21,
    **dadurch gekennzeichnet, dass** mindestens eine Gruppen-Überwachungseinheit (52) so ausgestaltet ist, dass sie

    - bei elektrisch in einer Parallelschaltung angeordneten Kondensatoreinheiten (C1, C2, C3, C4) einer Gruppe

        - für die Kondensatoreinheiten (C1, C2, C3, C4) der Parallelschaltung jeweils den Stromunterschied ($\Delta In$) zwischen dem durch diese Kondensatoreinheit fließenden Strom (In) und dem durchschnittlich durch die Kondensatoreinheiten fließenden Strom (Iav) ermittelt,
        - einen Mittelwert ($\Delta Iav$) der Stromunterschiede ($\Delta In$) der Kondensatoreinheiten ermittelt,
        - für die Kondensatoreinheiten jeweils das Verhältnis aus dem Stromunterschied ($\Delta In$) und dem Mittelwert ($\Delta Iav$) bildet,
        - die zeitliche Änderung des Verhältnisses ($\Delta In/\Delta Iav$) überwacht, und
        - das Auftreten eines defekten Kondensatorelements (CE3) bei der jeweiligen Kondensatoreinheit (C1) erkennt, wenn die zeitliche Änderung des Verhältnisses ($\Delta In/\Delta I-$

av) einen vorbestimmten ersten Schwellenwert (SW1) überschreitet, und/oder

- bei elektrisch in einer Reihenschaltung angeordneten Kondensatoreinheiten (C1, C2, C3, C4) einer Gruppe

- die über den Kondensatoreinheiten jeweils auftretende Kondensatoreinheiten-Spannung (UC1, UC2, UC3, UC4) ermittelt,
- jeweils den Spannungsunterschied (ΔUCn) zwischen den Kondensatoreinheiten-Spannungen (UC1, UC2, UC3, UC4) und der durchschnittlichen Kondensatoreinheiten-Spannung (UCav) der Kondensatoreinheiten der Reihenschaltung ermittelt,
- einen Mittelwert (ΔUav) dieser Spannungsunterschiede (ΔUCn) ermittelt,
- für die Kondensatoreinheiten das Verhältnis aus dem jeweiligen Spannungsunterschied (ΔUCn) und dem Mittelwert (ΔUav) bildet,
- die zeitliche Änderung des Verhältnisses (ΔUCn/ΔUav) überwacht, und
- das Auftreten eines defekten Kondensatorelements (CE3) bei der jeweiligen Kondensatoreinheit (C1) erkennt, wenn die zeitliche Änderung des Verhältnisses (ΔUCn/ΔUav) einen vorbestimmten zweiten Schwellenwert (SW2) überschreitet.

**23.** Anordnung nach Anspruch 22,
**dadurch gekennzeichnet, dass**

- die Kondensatoreinheiten jeweils mit einem Strompfad versehen sind, der die jeweilige Kondensatoreinheit verlässt und zum Herausführen eines Stromsignals (I8, I7, I6, I5), welches proportional zu der an einem Anschluss der jeweiligen Kondensatoreinheit auftretenden Spannung ist, aus der jeweiligen Kondensatoreinheit eingerichtet ist.

**Claims**

**1.** Method for monitoring a capacitor bank (1) which has a plurality of capacitor units (C1 ... C12), wherein each capacitor unit has a plurality of electrical capacitor elements (CE1 ... CEm), and wherein the capacitor units (C1 ... C12) are subdivided into several groups of capacitor units (C1 ... C4, C5 ... C8, C9 ... C12) and a group monitoring unit (52, 64, 68) is associated with each group of capacitor units (C1 ... C4, C5 ... C8, C9 ... C12),
wherein in the method

- each group of capacitor units (C1 ... C4) is monitored for a failure of a capacitor element (CE1 ... CEm) in one of the capacitor units (C1 ... C4) of the group by means of the associated group monitoring unit (52), and,
- when a failure of this kind of a capacitor element (CE3) is identified, data which describes this failure of the capacitor element (CE3) is transmitted from the group monitoring unit (52) to a monitoring receiver (72).

**2.** Method according to Claim 1,
**characterized in that**

- data about the capacitor unit (C1) containing the failed capacitor element (CE3) is transmitted from the group monitoring unit (52) to the monitoring receiver (72).

**3.** Method according to Claim 1 or 2,
**characterized in that**

- the capacitor elements which are arranged in the capacitor units (C1 ... C12) are connected electrically in parallel and/or in series.

**4.** Method according to one of the preceding claims,
**characterized in that**

- the capacitor units (C1 ... C12) each have a housing (48), in particular a metal housing (48), which surrounds all of the capacitor elements of the respective capacitor unit.

**5.** Method according to one of the preceding claims,
**characterized in that**

- the capacitor units (C1 ... C12) of the capacitor bank are arranged in at least one electrical series circuit and/or in at least one electrical parallel circuit.

**6.** Method according to one of the preceding claims,
**characterized in that**

- the group monitoring units (52) are each substantially at the electrical potential of the group of capacitor units (C1 ... C4) which is associated with them, and the monitoring receiver (72) is substantially at ground potential (24).

**7.** Method according to one of the preceding claims,
**characterized in that**

- the group monitoring units (64) are each supplied with electrical power which is coupled out from the group of capacitor units (C5 ... C8) with which the respective group monitoring unit (64) is associated.

8. Method according to Claim 7, **characterized in that**

   - the electrical power is coupled out from a magnetic field, which is formed on account of the electric current (I) flowing through the group of capacitor units (C5 ... C8), by means of a current transformer (308).

9. Method according to one of the preceding claims, **characterized in that**

   - the data about the failure of the capacitor element (CE3) is transmitted from the group monitoring unit (52) to the monitoring receiver (72) by means of a radio signal (304) and/or by means of an optical waveguide (306).

10. Method according to one of the preceding claims, **characterized in that**

    - the capacitor bank (1) has several levels (4, 8, 12) which are electrically insulated from one another and on each of which at least one of the groups of capacitor units (C1 ... C4) and the associated group monitoring unit (52) are arranged.

11. Method according to one of the preceding claims, **characterized in that**,

    - in the case of capacitor units (C1, C2, C3, C4) of a group which are arranged electrically in a parallel circuit,

      - the current difference ($\Delta$In) between the current (In) flowing through this capacitor unit and the current (Iav) flowing through the capacitor units on average is ascertained for each of the capacitor units (C1, C2, C3, C4) of the parallel circuit,
      - a mean value ($\Delta$Iav) of the current differences ($\Delta$In) of the capacitor units is ascertained,
      - the ratio of the current difference ($\Delta$In) and the mean value ($\Delta$Iav) is formed for each of the capacitor units,
      - the change in the ratio ($\Delta$In/$\Delta$Iav) with respect to time is monitored, and
      - the occurrence of a defective capacitor element (CE3) in the respective capacitor unit (C1) is identified when the change in the ratio ($\Delta$In/$\Delta$Iav) with respect to time exceeds a predetermined first threshold value (SW1), and/or,

    - in the case of capacitor units (C1, C2, C3, C4) of a group which are arranged electrically in a series circuit,

      - the capacitor unit voltage (UC1, UC2, UC3, UC4) which occurs across each of the capacitor units is ascertained,
      - the voltage difference ($\Delta$UCn) between the capacitor unit voltages (UCn) and the average capacitor unit voltage (UCav) of the capacitor units of the series circuit is ascertained in each case,
      - a mean value ($\Delta$Uav) of these voltage differences ($\Delta$UCn) is ascertained,
      - the ratio of the respective voltage difference ($\Delta$UCn) and the mean value ($\Delta$Uav) is formed for the capacitor units,
      - the change in the ratio ($\Delta$UCn/$\Delta$Uav) with respect to time is monitored, and
      - the occurrence of a defective capacitor element (CE3) in the respective capacitor unit (C1) is identified when the change in the ratio ($\Delta$UCn/$\Delta$Uav) with respect to time exceeds a predetermined second threshold value (SW2).

12. Method according to Claim 11, **characterized in that**

    - the electrical voltage which occurs in each case at a connection of the capacitor units is ascertained by means of a current signal (I8, I7, I6, I5) which is respectively fed out from the capacitor units and is proportional to the voltage which occurs at the connection of the respective capacitor unit and which is converted into a voltage signal outside the capacitor unit.

13. Arrangement

    - comprising a capacitor bank (1) which has a plurality of capacitor units (C1 ... C12), wherein each capacitor unit has a plurality of electrical capacitor elements (CE1 ... CEm), and wherein the capacitor units (C1 ... C12) are subdivided into several groups of capacitor units (C1 ... C4, C5 ... C8, C9 ... C12), and
    - comprising several group monitoring units (52, 64, 68), wherein one of the group monitoring units (52, 64, 68) is associated with each group of capacitor units (C1 ... C4, C5 ... C8, C9 ... C12), and at least one of the group monitoring units (52) is configured such that it monitors the respective group of capacitor units (C1 ... C4) for a failure of a capacitor element (CE1 ... CEm) in one of the capacitor units (C1 ... C4) of the group and, when a failure of this kind of a capacitor element (CE3) is identified, data which describes this failure of the capacitor element (CE3) is transmitted to a monitoring receiver (72).

14. Arrangement according to Claim 13, **characterized in that**

 - the capacitor elements which are arranged in the capacitor units (C1 ... C12) are connected electrically in parallel and/or in series.

15. Arrangement according to Claim 13 or 14, **characterized in that**

 - the capacitor units (C1 ... C12) each have a housing (48), in particular a metal housing (48), which surrounds all of the capacitor elements of the respective capacitor unit.

16. Arrangement according to one of Claims 13 to 15, **characterized in that**

 - the capacitor units (C1 ... C12) of the capacitor bank are arranged in at least one electrical series circuit and/or in at least one electrical parallel circuit.

17. Arrangement according to one of Claims 13 to 16, **characterized in that**

 - the group monitoring units (52) are each substantially at the electrical potential of the group of capacitor units (C1...C4) which is associated with them, and the monitoring receiver (72) is substantially at ground potential (24).

18. Arrangement according to one of Claims 13 to 17, **characterized in that**

 - a power supply device (308) is associated with at least one group monitoring unit (64), which power supply device couples out electrical power for supplying the group monitoring unit (64) from the group of capacitor units (C5 ... C8) with which the respective group monitoring unit (64) is associated.

19. Arrangement according to Claim 18, **characterized in that**

 - the group monitoring unit has a current transformer (308) which couples out the electrical power from a magnetic field which is formed on account of the electric current (I) flowing through the group of capacitor units (C5 ... C8).

20. Arrangement according to one of Claims 13 to 19, **characterized in that**

 - at least one group monitoring unit (64) has a wireless transmission unit which transmits the data about the failure of the capacitor element (CE3) to the monitoring receiver (72) by means of a radio signal (304), and/or
 - at least one group monitoring unit (64) is connected to the monitoring receiver (72) by means of an optical waveguide (306) in order to transmit the data about the failure of the capacitor element to the monitoring receiver (72) via the optical waveguide (306).

21. Arrangement according to one of Claims 13 to 20, **characterized in that**

 - the capacitor bank (1) has several levels (4, 8, 12) which are electrically insulated from one another and on each of which at least one of the groups of capacitor units (C1 ... C4) and the associated group monitoring unit (52) are arranged.

22. Arrangement according to one of Claims 13 to 21, **characterized in that** at least one group monitoring unit (52) is configured such that it,

 - in the case of capacitor units (C1, C2, C3, C4) of a group which are arranged electrically in a parallel circuit,

 - ascertains the current difference ($\Delta In$) between the current (In) flowing through this capacitor unit and the current (Iav) flowing through the capacitor units on average for each of the capacitor units (C1, C2, C3, C4) of the parallel circuit,
 - ascertains a mean value ($\Delta Iav$) of the current differences ($\Delta In$) of the capacitor units,
 - forms the ratio of the current difference ($\Delta In$) and the mean value ($\Delta Iav$) for each of the capacitor units,
 - monitors the change in the ratio ($\Delta In/\Delta Iav$) with respect to time, and
 - identifies the occurrence of a defective capacitor element (CE3) in the respective capacitor unit (C1) when the change in the ratio ($\Delta In/\Delta Iav$) with respect to time exceeds a predetermined first threshold value (SW1), and/or,

 - in the case of capacitor units (C1, C2, C3, C4) of a group which are arranged electrically in a series circuit,

 - ascertains the capacitor unit voltage (UC1, UC2, UC3, UC4) which occurs across each of the capacitor units,

- ascertains the voltage difference ($\Delta$UCn) between the capacitor unit voltages (UC1, UC2, UC3, UC4) and the average capacitor unit voltage (UCav) of the capacitor units of the series circuit in each case,
- ascertains a mean value ($\Delta$Uav) of these voltage differences ($\Delta$UCn),
- forms the ratio of the respective voltage difference ($\Delta$UCn) and the mean value ($\Delta$Uav) for the capacitor units,
- monitors the change in the ratio ($\Delta$UCn/$\Delta$Uav) with respect to time, and
- identifies the occurrence of a defective capacitor element (CE3) in the respective capacitor unit (C1) when the change in the ratio ($\Delta$UCn/$\Delta$Uav) with respect to time exceeds a predetermined second threshold value (SW2).

**23.** Arrangement according to Claim 22, **characterized in that**

- the capacitor units are each provided with a current path which leaves the respective capacitor unit and is designed for feeding out a current signal (18, 17, 16, I5), which is proportional to the voltage which occurs at a connection of the respective capacitor unit, from the respective capacitor unit.

## Revendications

**1.** Procédé de contrôle d'une batterie (1) de condensateurs, qui a une pluralité d'unités (C1 ... C12) de condensateurs, dans lequel chaque unité de condensateur a une pluralité d'éléments (CE1 ... CEm) de condensateur électriques, et dans lequel les unités (C1 ... C12) de condensateur sont réparties en plusieurs groupes d'unités (C1... C4, C5 ... C8, C9 ... C12) de condensateur et une unité (52, 64, 68) de contrôle de groupe est associée à chaque groupe d'unités (C1 ... C4, C5 ... C8, C9 ... C12) de condensateur,
dans lequel dans le procédé

- on contrôle chaque groupe d'unités (C1 ... C4) de condensateurs au moyen de l'unité (52) de contrôle de groupe associée sur le point de savoir s'il y a une défaillance d'un élément (CE1 ... CEm) de condensateur dans l'une des unités (C1 ... C4) de condensateur du groupe, et
- si l'on détecte une défaillance de ce genre d'un élément (CE3) de condensateur, on transmet de l'unité (52) de contrôle de groupe à un récepteur (72) de contrôle des données qui décrivent cette défaillance de l'élément (CE3) de condensateur.

**2.** Procédé suivant la revendication 1, **caractérisé en ce que**

- on transmet de l'unité (52) de contrôle de groupe au récepteur (72) de contrôle des données sur l'unité (C1) de condensateur ayant l'élément (CE3) de condensateur défaillant.

**3.** Procédé suivant la revendication 1 ou 2, **caractérisé en ce que**

- les éléments de condensateur disposés dans les unités (C1 ... C12) de condensateurs sont montés électriquement en parallèle et/ou en série.

**4.** Procédé suivant l'une des revendications précédentes, **caractérisé en ce que**

- les unités (C1 ... C12) de condensateurs ont respectivement un boîtier (48), notamment un boîtier (48) métallique, qui entoure tous les éléments de condensateur de l'unité de condensateur respective.

**5.** Procédé suivant l'une des revendications précédentes, **caractérisé en ce que**

- les unités (C1 ... C12) de condensateurs de la batterie de condensateurs sont montés dans au moins un circuit électrique en série et/ou dans au moins un circuit électrique en parallèle.

**6.** Procédé suivant l'une des revendications précédentes, **caractérisé en ce que**

- les unités (52) de contrôle de groupe sont montées respectivement sur sensiblement le même potentiel électrique du groupe, qui leur est associé, d'unités (C1 ... C4) de condensateur et le récepteur (72) de contrôle est mis sensiblement au potentiel (24) de terre.

**7.** Procédé suivant l'une des revendications précédentes, **caractérisé en ce que**

- on alimente les unités (64) de contrôle de groupe respectivement en énergie électrique, que l'on extrait du groupe d'unités (C5 ... C8) de condensateur, auquel l'unité (64) respective de contrôle de groupe est associée.

**8.** Procédé suivant la revendication 7, **caractérisé en ce que**

- on extrait l'énergie électrique au moyen d'un transformateur (308) de courant d'un champ magnétique, qui se forme en raison du courant (I) électrique passant dans le groupe des unités (C5 ... C8) de condensateurs.

9. Procédé suivant l'une des revendications précédentes, **caractérisé en ce que**

- on transmet de l'unité (52) de contrôle de groupe au récepteur (72) de contrôle les données sur la défaillance de l'élément (CE3) de condensateur au moyen d'un signal (304) radio et/ou au moyen d'une fibre (306) optique.

10. Procédé suivant l'une des revendications précédentes, **caractérisé en ce que**

- la batterie (1) de condensateurs a plusieurs étages (4, 8, 12) isolés électriquement les uns par rapport aux autres, sur lesquels sont montés respectivement au moins l'un des groupes d'unités (C1 ... C4) de condensateurs et l'unité (52) associée de contrôle de groupe.

11. Procédé suivant l'une des revendications précédentes, **caractérisé en ce que**

- pour des unités (C1, C2, C3, C4) de condensateur, montées électriquement suivant un circuit en parallèle d'un groupe

- on détermine pour les unités (C1, C2, C3, C4) de condensateurs du circuit en parallèle respectivement la différence (ΔIn) de courant entre le courant (In) passant dans cette unité de condensateur et le courant (Iav) passant en moyenne dans les unités de condensateur,
- on détermine une valeur (ΔIav) moyenne des différences (ΔIn) de courant des unités de condensateur,
- pour les unités de condensateur, on forme respectivement le rapport de la différence (ΔIn) de courant à la valeur (ΔIav) moyenne,
- on contrôle la variation en fonction du temps du rapport (ΔIn/ΔIav), et
- on détecte l'apparition d'un élément (CE3) de condensateur défectueux dans l'unité (C1) respective de condensateur si la variation en fonction du temps du rapport (ΔIn/ΔIav) dépasse une première valeur (SW1) de seuil définie à l'avance, et/ou

- pour des unités (C1, C2, C3, C4) de condensateur montées électriquement suivant un circuit en série d'un groupe

- on détermine la tension (UC1, UC2, UC3, UC4) d'unité de condensateur se produisant respectivement sur les unités de condensateur,
- on détermine respectivement la différence (ΔUCn) de tension entre les tensions (UCn) d'unités de condensateur et la tension (UCav) d'unité de condensateur en moyenne des unités de condensateur du circuit série,
- on détermine une valeur (ΔUav) moyenne de ces différences (ΔUCn) de tension,
- pour les unités de condensateur, on forme le rapport de la différence (ΔUCn) respective de tension à la valeur (ΔUav) moyenne,
- on contrôle la variation en fonction du temps du rapport (ΔUCn/ΔUav), et
- on détecte l'apparition d'un élément (CE3) de condensateur défectueux dans l'unité (C1) respective de condensateur, si la variation en fonction du temps du rapport (ΔUCn/ΔUav) dépasse une deuxième valeur (SW2) de seuil définie à l'avance.

12. Procédé suivant la revendication 11, **caractérisé en ce que**

- l'on détermine la tension électrique respective apparaissant à une borne des unités de condensateur au moyen d'un signal (I8, I7, I6, I5) de courant sorti respectivement des unités de condensateur, qui est proportionnel à la tension apparaissant à la borne de l'unité respective de condensateur et que l'on transforme à l'extérieur de l'unité de condensateur en un signal de tension.

13. Montage

- comprenant une batterie (1) de condensateurs, qui a une pluralité d'unités (C1 ... C12) de condensateurs, dans lequel chaque unité de condensateur à une pluralité d'éléments (CE1 ... CEm) de condensateurs électriques et dans lequel les unités (C1 ... C12) de condensateur sont réparties en plusieurs groupes d'unités (C1 ... C4, C5 ... C8, C9 ... C12) de condensateur, et
- comprenant plusieurs unités (52, 64, 68) de contrôle de groupe, dans lequel l'une des unités (52, 64, 68) de contrôle de groupe est associée à chaque groupe d'unités (C1 ... C4, C5 ... C8, C9 ... C12) de condensateur et au moins l'une des unités (52) de contrôle de groupe est conformée pour contrôler le groupe respectif d'unités (C1 ... C4) de condensateur sur le point de savoir s'il y a une défaillance d'un élément (CE1 ... CEm) de condensateur dans l'une des unités (C1 ... C4) de condensateur du groupe et, si une défaillance de ce genre d'un élément (CE3) de condensateur est détectée, pour transmettre à un récepteur (72) de contrôle des données, qui décrivent cette défaillance de l'élément (CE3) de condensateur.

**14.** Montage suivant la revendication 13, **caractérisé en ce que**

- les éléments de condensateur disposés dans les unités (C1 ... C12) de condensateur sont montés électriquement en parallèle et/ou en série.

**15.** Montage suivant la revendication 13 ou 14, **caractérisé en ce que**

- les unités (C1 ... C12) de condensateur ont respectivement un boîtier (48), notamment un boîtier (48) métallique, qui entoure tous les éléments de condensateur de l'unité de condensateur respective.

**16.** Montage suivant l'une des revendications 13 à 15, **caractérisé en ce que**

- les unités (C1 ... C12) de condensateur de la batterie de condensateurs sont montées dans au moins un circuit électrique en série et/ou dans au moins un circuit électrique en parallèle.

**17.** Montage suivant l'une des revendications 13 à 16, **caractérisé en ce que**

- les unités (52) de contrôle de groupe sont montées respectivement sur sensiblement le même potentiel électrique du groupe, qui leur est associé, d'unité (C1 ... C4) de condensateur et le récepteur (72) de contrôle est mis sensiblement au potentiel (24) de terre.

**18.** Montage suivant l'une des revendications 13 à 17, **caractérisé en ce que**

- à au moins une unité (64) de contrôle de groupe est associée un dispositif (308) d'alimentation en énergie, qui extrait l'énergie électrique pour l'alimentation de l'unité (64) de contrôle de groupe du groupe d'unités (C5 ... C8) de condensateur, auquel l'unité (64) respective de contrôle de groupe est associée.

**19.** Montage suivant la revendication 18, **caractérisé en ce que**

- l'unité de contrôle de groupe a un transformateur (308) de courant, qui extrait l'énergie électrique d'un champ magnétique formé en raison du courant (I) électrique passant dans le groupe des unités (C5 ... C8) de condensateur.

**20.** Montage suivant l'une des revendications 13 à 19, **caractérisé en ce que**

- au moins une unité (64) de contrôle de groupe a une unité de transfert sans fil, qui transmet les données sur la défaillance de l'élément (CE3) de condensateur au moyen d'un signal (304) radio au récepteur (72) de contrôle, et/ou
- au moins une unité (64) de contrôle de groupe est reliée au récepteur (72) de contrôle au moyen d'une fibre (306) optique pour transmettre les données sur la défaillance de l'élément de condensateur par la fibre (306) optique au récepteur (72) de contrôle.

**21.** Montage suivant l'une des revendications 13 à 20, **caractérisé en ce que**

- la batterie (1) de condensateurs a plusieurs étages (4, 8, 12) isolés électriquement les uns par rapport aux autres, sur lesquels sont montés respectivement au moins l'un des groupes d'unités (C1 ... C4) de condensateur et l'unité (52) associée de contrôle de groupe.

**22.** Montage suivant l'une des revendications 13 à 21, **caractérisé en ce que**
au moins une unité (52) de contrôle de groupe est conformée de manière

- pour des unités (C1, C2, C3, C4) de condensateur montées électriquement suivant un circuit en parallèle d'un groupe

- à déterminer pour les unités (C1, C2, C3, C4) de condensateur du circuit en parallèle, respectivement la différence ($\Delta$In) de courant entre le courant (In) passant dans cette unité de condensateur et le courant (Iav) passant en moyenne dans les unités de condensateur,
- à déterminer une valeur ($\Delta$Iav) moyenne des différences ($\Delta$In) de courant des unités de condensateur,
- à former pour les unités de condensateur respectivement le rapport de la différence ($\Delta$In) de courant à la valeur ($\Delta$Iav) moyenne,
- contrôler la variation en fonction du temps de rapport ($\Delta$In/$\Delta$Iav), et
- détecter l'apparition d'un élément (CE3) de condensateur défectueux dans l'unité (C1) respective de condensateur, si la variation en fonction du temps du rapport ($\Delta$In/$\Delta$Iav) dépasse une première valeur (SW1) de seuil définie à l'avance, et/ou

- pour des unités (C1, C2, C3, C4) de condensateur montées électriquement suivant un circuit en série d'un groupe,

- à déterminer la tension (UC1, UC2, UC3, UC4) d'unité de condensateur se produisant respectivement sur les unités de condensateur,
- à déterminer respectivement la différence ($\Delta$UCn) de tension entre les tensions (UC1, UC2, UC3, UC4) d'unités de condensateur et la tension (UCav) moyenne d'unités de condensateur des unités de condensateur des circuits en série,
- à déterminer une valeur ($\Delta$Uav) moyenne de ces différences ($\Delta$UCn) de tension,
- à former pour les unités de condensateur le rapport de la différence ($\Delta$UCn) respective de tension et de la valeur ($\Delta$Uav) moyenne,
- à contrôler la variation en fonction du temps du rapport ($\Delta$UCn/$\Delta$Uav), et
- à détecter l'apparition d'un élément (CE3) défectueux de condensateur dans l'unité (C1) respective de condensateur, si la variation en fonction du temps du rapport ($\Delta$UCn/$\Delta$Uav) dépasse une deuxième valeur (SW2) de seuil définie à l'avance.

23. Montage suivant la revendication 22, **caractérisé en ce que**

- les unités de condensateur sont pourvues chacune d'un trajet de courant qui quitte l'unité respective de condensateur et qui est conçu pour la sortie d'un signal (I8, I7, I6, I5) de courant de l'unité respective de condensateur, qui est proportionnel à la tension apparaissant à une borne de l'unité respective de condensateur.

# FIG 1

# FIG 2

FIG 3

FIG 4

FIG 5

# FIG 6

FIG 7

# FIG 8

C8

C7

U8

U7

810  810'

32

I8

I7

812  812

830

812  812

U8'  ΔU  U7'

ΔU=U8'-U7'

32

FIG 9

$\Delta U8 = U8' - U7'$
$\Delta U7 = U7' - Ur'$
$\Delta U6 = Ur' - U6'$
$\Delta U5 = U6' - U5'$

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2017059639 A1